# FASCICULE DE BREVET EUROPEEN

(11) **EP 4 020 479 B1**
(45) Date de publication et mention de la délivrance du brevet: **17.09.2025**
(21) Numéro de dépôt: 21212530.6
(22) Date de dépôt: 06.12.2021
(51) Int. Cl.: G11C 13/00

(54) **LECTURE DIFFÉRENTIELLE DE MÉMOIRE RRAM À FAIBLE CONSOMMATION**
DIFFERENTIELLES LESEN EINES RRAM-SPEICHERS MIT GERINGEM STROMVERBRAUCH
DIFFERENTIAL READING OF RRAM MEMORY WITH LOW POWER CONSUMPTION

(30) Priorité: 22.12.2020 FR 2013879
(43) Date de publication de la demande: 29.06.2022
(73) Titulaire: Commissariat à l'Energie Atomique et aux Energies Alternatives, 75015 Paris (FR)
(72) Inventeur: RUMMENS, François, 38054 GRENOBLE Cedex 09 (FR)
(74) Mandataire: Brevalex

(56) Documents cités:
- US-A1- 2003 198 081
- US-A1- 2016 293 253
- US-A1- 2019 341 107
- US-B1- 6 317 359
- TIFENN HIRTZLIN ET AL: "Digital Biologically Plausible Implementation of Binarized Neural Networks with Differential Hafnium Oxide Resistive Memory Arrays", ARXIV.ORG, CORNELL UNIVERSITY LIBRARY, 201 OLIN LIBRARY CORNELL UNIVERSITY ITHACA, NY 14853, 12 August 2019 (2019-08-12), XP081460031

## Description

### DOMAINE TECHNIQUE

La présente invention a trait au domaine des mémoires résistives non-volatiles RRAM encore notées ReRAM (pour « Resistive Random Access Memory ») et plus particulièrement à l'optimisation des opérations de lecture de telles mémoires.

### ÉTAT DE LA TECHNIQUE ANTÉRIEURE

Typiquement, une cellule mémoire ReRAM est dotée d'au moins un élément résistif dont on peut modifier la conductance et qui est susceptible d'adopter au moins deux niveaux de résistance bien distincts : un premier niveau, dit « HRS », de résistance dit « élevé » (HRS pour « High Resistive State ») et un deuxième niveau, dit « LRS » (pour « Low Resistive State ») de résistance plus faible que le niveau HRS. L'écart entre la plus faible valeur correspondant à un niveau HRS et la plus haute valeur correspondant au niveau LRS, également appelé « fenêtre mémoire », est toutefois souvent faible. Dès lors, on utilise couramment un « encodage différentiel » pour coder une valeur binaire mémorisée.

Ainsi, on peut encoder chaque bit d'information en constituant des cellules élémentaires formée de deux éléments résistifs qui seront, écrits en opposition d'état, c'est-à-dire avec un des éléments résistifs ayant un niveau HRS et l'autre un niveau LRS, les niveaux respectifs de résistance des deux éléments résistifs étant déterminés toujours dans le même ordre entre les deux éléments et définira suivant qu'il correspond à HRS-LRS ou LRS-HRS si l'on est en présence d'un '0' ou d'un '1' logique.

Une technique de lecture d'une donnée stockée dans un tel type de cellule mémoire est décrite dans le document : « Hybrid Analog-Digital Learning with Differential RRAM synapses » de Bocquet et al. IEDM19-534.

Elle utilise un circuit de lecture doté d'un amplificateur de détection de type à verrouillage qui, lors d'une opération de lecture, est couplé à la paire différentielle d'éléments résistifs par l'intermédiaire d'une paire de lignes de bits et est dotée de nœuds dont les potentiels basculent en fonction de valeurs de courant qui traversent les éléments résistifs. Un tel type d'amplificateur de détection est réalisé avec peu de transistors et fonctionne comme un amplificateur différentiel de courant à fort gain. Il permet de comparer directement des courants qui traversent les éléments résistifs et circulent via des lignes de bits.

Le circuit de lecture muni d'un tel amplificateur est peu encombrant, permet de déterminer rapidement la donnée mémorisée et n'induit pas de consommation statique.

Il se pose cependant le problème de la consommation dynamique induite par l'opération de lecture.

Lors d'une telle opération, les nœuds d'une cellule connectés aux lignes de bits se déchargent en passant typiquement d'une valeur de pré-charge correspondant à une tension d'alimentation VDD à une tension de référence GND ou inversement. Cette décharge dépend de la capacité des lignes de bits qui est importante et entraine une forte consommation.

Le document de l'art antérieur US 2019/341107 A1 décrit un dispositif de mémoire résistive qui comprend des éléments pour une initialisation in situ d'éléments de changement résistifs dans une matrice.

Plus généralement, il se pose le problème de réaliser un nouveau dispositif mémoire ReRAM dont la mise en œuvre des opérations de lecture soit améliorée.

### EXPOSÉ DE L'INVENTION

Selon un aspect, la présente demande concerne un dispositif de mémoire résistive à accès aléatoire (ReRAM) comprenant :
- une matrice de cellules mémoires chacune reliée à une première ligne d'alimentation mise à un premier potentiel d'alimentation, chaque cellule de ladite matrice étant dotée d'au moins un premier élément résistif de résistivité variable et en série avec au moins un premier transistor de sélection,

- un circuit de lecture associé à une colonne de cellules de la matrice, le circuit de lecture comprenant :
   - un amplificateur de détection de type à verrouillage formé d'inverseurs connectés de façon croisée et muni d'un premier nœud de lecture et d'un deuxième nœud de lecture, lesdits inverseurs formant respectivement une première branche et une deuxième branche reliées chacune d'un côté à une deuxième ligne d'alimentation mise à un deuxième potentiel d'alimentation, distinct dudit premier potentiel d'alimentation,
   - au moins un premier transistor de couplage reliant un autre côté de ladite première branche à une première ligne de bits couplée aux premiers éléments résistifs respectifs des cellules de ladite colonne,
- au moins un deuxième transistor de couplage reliant un autre côté de ladite deuxième branche soit à une deuxième ligne de bits couplée à des deuxièmes éléments résistifs des cellules de ladite colonne, soit à une ligne de référence délivrant un courant de référence ;
   - un circuit de commande des opérations de lecture sur la matrice par le biais de signaux de commande d'éléments interrupteurs, ledit circuit de commande étant configuré pour, lors d'une opération de lecture effectuée sur une cellule donnée de ladite colonne :
      - selon une phase d'attente, coupler ladite première ligne de bit à la première ligne d'alimentation ou bien charger ladite première ligne de bit à un potentiel égal ou proche ou sensiblement égal audit premier potentiel d'alimentation, puis,
      - selon une phase de réinitialisation dudit amplificateur de détection, par le biais d'au moins un transistor de réinitialisation relier le premier nœud et le deuxième noeud afin d'égaliser les potentiels du premier nœud de lecture et du deuxième nœud de lecture ;
      - selon une phase de décharge partielle, relier la première ligne de bits à la deuxième ligne d'alimentation et, dans le cas où le dispositif comporte une deuxième ligne de bits, relier la deuxième ligne de bits à la deuxième ligne d'alimentation, la phase de réinitialisation étant déclenchée pendant la phase de décharge partielle ; puis
      - selon une phase de comparaison, rendre passant lesdits premier et deuxième transistors de couplage et rendre non passant ou bloqué ledit au moins un transistor de réinitialisation est rendu non passant.

Lors de la phase de décharge partielle on peut ainsi décharger partiellement ladite première ligne de bit ou lesdites lignes de bits et on obtient aux bornes des cellules de ladite colonne une différence de potentiel non nulle tout en étant inférieure, et en particulier bien inférieure, à une différence de potentiels entre le premier potentiel d'alimentation et ledit deuxième potentiel d'alimentation.

Contrairement à un dispositif conventionnel où l'on effectue une charge/décharge de ligne de bits d'un potentiel d'alimentation VDD jusqu'à un potentiel de référence GND ou inversement, on fait ici en sorte lors, de l'opération de lecture, de réduire l'amplitude de charge ou de décharge de la ligne de bit lors ce qui permet d'améliorer la consommation dynamique.

La phase de décharge partielle permet ici également d'améliorer la fiabilité de la donnée produite en sortie du circuit de lecture et que cette sortie ne bascule vers un état décorrélé de l'état résistif du ou des éléments résistifs de la cellule à laquelle on accède en lecture.

Lors de la phase de comparaison, on permet une circulation d'un premier courant : à travers ladite première branche dudit amplificateur de détection, la première ligne de bit et un premier élément résistif de ladite cellule et une circulation d'un deuxième courant à travers ladite deuxième branche dudit amplificateur de détection ainsi que soit la ligne de référence soit la deuxième ligne de bit et un deuxième élément résistif de ladite cellule, jusqu'à un basculement dudit amplificateur de détection en fonction d'une différence entre lesdits premier et deuxième courants.

Parmi lesdits éléments interrupteurs peut figurer au moins un premier élément interrupteur appartenant à un étage de réinitialisation dudit amplificateur de détection, et qui est commandé par le biais d'un premier signal de commande.

Avantageusement, le circuit de commande est configuré en outre pour :
- lors de ladite phase de décharge partielle, placer ledit premier signal de commande dans un premier état, de sorte à maintenir fermé (passant) ledit au moins un premier élément interrupteur de manière à connecter entre eux le premier nœud de lecture et le deuxième nœud de lecture, ou de manière à connecter le premier nœud de lecture et le deuxième nœud de lecture à la deuxième ligne d'alimentation ou de manière à connecter une première borne et une deuxième borne de chacun desdits premier inverseur et du deuxième inverseur à la deuxième ligne d'alimentation, puis,
- lors de la phase de comparaison mettre le premier signal de commande dans un deuxième état, distinct dudit premier état, de sorte que ledit premier élément interrupteur est ouvert.

Ledit au moins un premier élément interrupteur peut être formé ou comprendre un premier transistor de réinitialisation, ledit circuit de commande étant configuré pour :
- lors de ladite phase de réinitialisation, maintenir passant le premier transistor de réinitialisation, et
- lors de la phase de comparaison mettre le premier signal de commande dans un deuxième état, distinct dudit premier état, de sorte que ledit premier transistor de réinitialisation est non-passant et en particulier bloqué.

Lors de ladite phase de réinitialisation le premier transistor de réinitialisation peut être maintenu passant, de sorte à relier entre eux le premier nœud de lecture et le deuxième nœud de lecture, ou relier le premier nœud de lecture à la deuxième ligne d'alimentation ou relier une première borne et une deuxième borne du premier inverseur à la deuxième ligne d'alimentation.

Selon un premier mode de réalisation particulier, le premier transistor de couplage comprend ou est sous forme d'un premier transistor d'isolation agencé entre ledit amplificateur de détection et ladite première ligne de bit, le premier d'isolation étant commandé par le biais d'au moins un deuxième signal de commande, le circuit de commande étant configuré en outre pour : lors de la phase d'attente de l'opération de lecture préalable à ladite phase de décharge partielle, mettre le premier signal de commande dans un premier état de sorte que ledit au moins un élément interrupteur est fermé tandis que ledit deuxième signal de commande est mis par ledit circuit de commande dans un état donné de sorte à rendre bloqué le premier transistor d'isolation et isoler ainsi la première ligne de bit dudit amplificateur de détection, le circuit de commande étant configuré en outre pour, lors desdites phases de décharge partielle et de comparaison : mettre le deuxième signal de commande dans un autre état, distinct dudit état donné, de sorte à rendre passant le premier transistor d'isolation et connecter ainsi la première ligne de bit audit amplificateur de détection.

Avantageusement, lors de la phase d'attente, ledit premier signal de commande peut être mis dans un état de sorte à maintenir passant le premier transistor de réinitialisation. Ainsi, on peut met en œuvre, en parallèle de la phase d'attente, ladite phase de réinitialisation dudit amplificateur de détection.

Selon une possibilité de mise en œuvre, les cellules mémoires sont de type 2T-2R et dotées chacune d'au moins un autre élément résistif couplé à un autre transistor de sélection, la rangée donnée de cellules de la matrice de cellules étant alors couplée à une deuxième ligne de bits, le dispositif étant doté en outre : d'un deuxième transistor d'isolation entre l'amplificateur de détection et la deuxième ligne de bit, le premier et deuxième transistors d'isolation étant commandés par le biais dudit deuxième signal de commande.

Avantageusement, le circuit de lecture de lecture peut comprendre en outre : un troisième transistor d'isolation et un quatrième transistor d'isolation connectés de façon croisée de sorte que le troisième transistor d'isolation a une première électrode couplée au premier transistor d'isolation et une deuxième électrode couplée au deuxième transistor d'isolation et de sorte que le quatrième transistor d'isolation a une première électrode couplée au deuxième transistor d'isolation et une deuxième électrode couplée au premier transistor d'isolation.

Une telle configuration peut permettre au dispositif de mémoire résistive à accès aléatoire d'effectuer des opérations en mémoire, en particulier au moins une opération logique.

Le circuit de commande peut être alors doté en outre : d'un bloc logique de commande configuré pour produire des signaux de pilotage des grilles respectives desdits transistors d'isolation en fonction d'au moins un signal numérique de sélection de mode de fonctionnement émis sur une ou plusieurs entrées dudit bloc logique de commande et d'une donnée logique volatile en entrée dudit bloc logique de commande, pour sélectionner entre un premier mode de fonctionnement du circuit de lecture correspondant à une opération de lecture et au moins un autre mode de fonctionnement du circuit de lecture correspondant à la mise en œuvre d'au moins une opération logique entre au moins une donnée non-volatile mémorisée dans la cellule donnée de la rangée donnée de cellules et la donnée logique volatile en entrée dudit bloc logique de commande, ledit bloc logique de commande étant configuré pour :
- lorsque le signal numérique de sélection a une première valeur correspondant à une sélection d'une opération de lecture : appliquer des signaux de pilotage de la grille du premier transistor d'isolation et à la grille du deuxième transistor d'isolation correspondants au deuxième signal de commande,
- lorsque le signal numérique de sélection a une autre valeur distincte de la première valeur et correspondant à une sélection d'une opération logique : transmettre un premier signal de pilotage à la grille du premier transistor d'isolation et un deuxième signal de pilotage à la grille du deuxième transistor d'isolation, de sorte à bloquer l'un desdits premier et deuxième transistors d'isolation tout en rendant passant l'autre desdits premier et deuxième transistors d'isolation.

Avantageusement, le circuit de lecture de lecture peut comprendre en outre :
- un troisième transistor d'isolation et un quatrième transistor d'isolation connectés de façon croisée, le bloc logique de commande étant configuré en outre pour produire un signal de pilotage des grilles respectives desdits troisième et quatrième transistors d'isolation et dans lequel :
   - lorsque ladite autre valeur est une deuxième valeur correspondant à une sélection d'une première opération logique, en particulier de type OU ou de type ET, le bloc logique de commande est configuré de sorte à produire un premier signal de pilotage, un deuxième signal de pilotage distinct du premier signal de pilotage, de sorte à rendre passant le premier transistor d'isolation tout en rendant bloqué le deuxième transistor d'isolation,
   - lorsque ladite autre valeur est une troisième valeur correspondant à une sélection d'une deuxième opération logique, en particulier de type ET ou de type OU : transmettre un premier signal de pilotage et un deuxième signal de pilotage de sorte à rendre bloqué le premier transistor d'isolation tout en rendant passant le deuxième transistor d'isolation,
   - lorsque le signal numérique de sélection a une quatrième valeur correspondant à une sélection d'une troisième opération logique, en particulier de type XOR, ledit bloc logique de sélection est configuré de sorte à transmettre un premier signal de pilotage à la grille du premier transistor d'isolation et un deuxième signal de pilotage à la grille du deuxième transistor d'isolation identique au premier signal de pilotage, le troisième signal de pilotage étant dans un état distinct de celui du premier signal de pilotage et du deuxième signal de pilotage.

Selon une possibilité de mise en œuvre, l'élément interrupteur de l'étage de réinitialisation précité peut comprendre :
- un premier transistor de réinitialisation couplé au deuxième nœud et à la deuxième ligne d'alimentation, le premier transistor de réinitialisation ayant une grille commandée par le premier signal de commande,
- un deuxième transistor de réinitialisation couplé au premier nœud et à la deuxième ligne d'alimentation, le deuxième transistor de réinitialisation ayant une grille commandée par le premier signal de commande.

Selon une variante, l'élément interrupteur de l'étage de réinitialisation peut comprendre : un transistor de réinitialisation ayant une grille commandée par le premier signal de commande, le transistor de réinitialisation étant agencé entre ledit premier nœud et ledit deuxième nœud.

Afin d'éviter une perte d'information, en particulier lors de réinitialisations de l'amplificateur de détection, le circuit de lecture peut être prévu en outre pour, en sortie dudit amplificateur de détection, être doté d'au moins un élément de mémorisation, configuré pour, lors de la phase dite « d'attente » mémoriser une donnée en sortie dudit amplificateur de détection d'une opération de lecture précédente.

Cet élément de mémorisation peut être en particulier doté :
- d'une bascule RS dotée d'une entrée couplée au premier nœud de lecture et d'une autre entrée couplée au deuxième nœud de lecture, ou
- d'une bascule D comprenant une entrée couplée au premier nœud de lecture ou au deuxième nœud de lecture.

Avantageusement, le premier transistor de sélection est commandé par une ligne de mot et prévu pour lorsqu'il est activé, coupler la première ligne de bit au premier élément résistif, lui-même étant relié à la ligne de source, la ligne de mot étant maintenue à un potentiel pendant la phase d'attente, la phase de décharge et la phase de comparaison de l'opération de lecture de sorte à maintenir activé le premier transistor de sélection et coupler la première ligne de bit à la ligne de source.

Selon un mode avantageux, le comparateur peut être amené à recevoir une tension mesurée de la première ligne de bit et le circuit de commande peut être doté d'un deuxième comparateur qui reçoit une autre tension mesurée de la deuxième ligne de bits, l'état du premier signal de commande dépendant en outre d'une comparaison effectuée par le deuxième comparateur.

Le dispositif peut comprendre en outre au moins une porte logique réalisant une fonction logique OU ou une fonction logique ET entre une sortie du comparateur et une sortie du deuxième comparateur.

De manière avantageuse, le dispositif peut comprendre en outre :
au moins un premier transistor dit « de repolarisation » agencé entre la première ligne de bit et ladite première ligne d'alimentation, le premier transistor de repolarisation étant configuré pour, en fonction d'un signal de pilotage de repolarisation appliqué sur sa grille, alternativement coupler la première ligne d'alimentation à la première ligne de bit et découpler la première ligne d'alimentation de la première ligne de bit. De tels transistors de repolarisation peuvent permettre de pouvoir enchaîner plusieurs opérations plus rapidement.

Avantageusement, en particulier pour permettre de protéger le circuit de lecture lors d'opérations d'écritures, le dispositif peut être pourvu d'un premier transistor de séparation entre la première ligne de bit et l'amplificateur de détection. Ainsi, ledit au moins un premier transistor de couplage peut être ou comprendre le premier transistor de séparation entre la première ligne de bit et l'amplificateur de détection.

Le premier transistor de séparation étant commandé par un signal de commande supplémentaire appelé « signal d'activation de lecture », le circuit de commande étant configuré pour mettre le signal d'activation de lecture dans un état déterminé lors de ladite opération de lecture de sorte à rendre passant le premier transistor de séparation, et mettre le signal d'activation de lecture dans un autre état, distinct dudit état déterminé, lors d'une opération d'écriture sur la matrice de sorte à bloquer le premier transistor de séparation.

Avantageusement, ledit au moins un premier transistor de couplage inclue un transistor avec un diélectrique de grille plus épais que le diélectrique de grille de transistors constitutifs dudit amplificateur de détection.

Selon un deuxième mode de réalisation, avantageusement, lors de phase de décharge partielle, la première ligne de bits est reliée à la deuxième ligne d'alimentation par l'intermédiaire d'un premier transistor de réinitialisation rendu passant par le biais d'un premier signal de commande, et par l'intermédiaire du premier transistor de couplage rendu passant par le biais d'un deuxième signal de commande.

Avantageusement, lors de la phase d'attente suivant une phase de comparaison d'une précédente opération de lecture, l'amplificateur de détection peut être maintenu dans un état verrouillé après son basculement, sans réinitialisation, et ladite première ligne de bits se recharge par un courant traversant au moins une cellule sélectionnée de ladite colonne.

Avantageusement, la phase de réinitialisation est alors réalisée uniquement en parallèle de la phase de décharge partielle.

Parmi lesdits éléments interrupteurs peut figurer au moins un élément interrupteur commandé par le biais d'un premier signal de commande et dans lequel ledit circuit de commande est doté en outre d'un premier comparateur qui reçoit une tension mesurée de la première ligne de bit, et produit en sortie le premier signal de commande dont l'état dépend d'une comparaison effectuée par ledit premier comparateur entre ladite tension mesurée et une tension référence prédéterminée.

Ladite colonne peut être couplée à une première ligne de bits et à une deuxième ligne de bits, et le circuit de commande peut être doté d'un deuxième comparateur qui reçoit une autre tension mesurée de ladite deuxième ligne de bits, l'état du premier signal de commande dépendant en outre d'une comparaison effectuée par ledit deuxième comparateur.

Selon un autre aspect, la présente demande concerne un dispositif de mémoire résistive à accès aléatoire (ReRAM) comprenant :
- une matrice de cellules mémoires chacune reliée à une première ligne d'alimentation mise à un premier potentiel d'alimentation, chaque cellule de ladite matrice étant dotée d'au moins un premier élément résistif de résistivité variable et en série avec au moins un premier transistor de sélection,

- un circuit de lecture associé à une colonne de cellules de la matrice, le circuit de lecture comprenant :
   - un amplificateur de détection de type à verrouillage formé d'inverseurs connectés de façon croisée et muni d'un premier nœud de lecture et d'un deuxième nœud de lecture, lesdits inverseurs formant respectivement une première branche et une deuxième branche reliées chacune d'un côté à une deuxième ligne d'alimentation mise à un deuxième potentiel d'alimentation, distinct dudit premier potentiel d'alimentation,
   - au moins un premier transistor de couplage reliant un autre côté de ladite première branche à une première ligne de bits couplée aux premiers éléments résistifs respectifs des cellules de ladite colonne,
   - au moins un deuxième transistor de couplage reliant un autre côté de ladite deuxième branche soit à une deuxième ligne de bits couplée à des deuxièmes éléments résistifs des cellules de ladite colonne, soit à une ligne de référence délivrant un courant de référence ;
   - un circuit de commande des opérations de lecture sur la matrice par le biais de signaux de commande d'éléments interrupteurs, ledit circuit de commande étant configuré pour, lors d'une opération de lecture effectuée sur une cellule donnée de ladite colonne :
      - selon une phase d'attente, coupler ladite première ligne de bit à la première ligne d'alimentation ou bien charger ladite première ligne de bit à un potentiel égal ou proche ou sensiblement égal audit premier potentiel d'alimentation tout en découplant la première ligne de bit de l'amplificateur de détection ou bien tout en couplant la première ligne de bit audit amplificateur de détection mais en maintenant l'amplificateur de détection dans un état verrouillé (basculé) de haute impédance,
         puis,
      - selon un cycle suivant la phase d'attente et comprenant une phase de décharge partielle puis une phase de comparaison, coupler la première ligne de bit dudit amplificateur de détection et maintenir couplée, la première ligne de bit audit premier élément résistif.

Le dispositif peut comprend en outre :
- au moins un premier transistor dit « de repolarisation » agencé entre la première ligne de bit et ladite première ligne d'alimentation, le premier transistor de repolarisation étant configuré pour, en fonction d'un signal de pilotage de repolarisation appliqué sur sa grille, alternativement coupler la première ligne d'alimentation à la première ligne de bit et découpler la première ligne d'alimentation de la première ligne de bit, ledit premier transistor de repolarisation étant rendu conducteur dans une phase d'attente et non conducteur lors desdites phases de décharge partielle et de comparaison.

Le circuit de commande peut être configuré en outre pour, selon une phase de réinitialisation, déclenchée typiquement lors de la décharge partielle, relier le premier nœud de lecture et le deuxième nœud de lecture de sorte à égaliser leurs potentiels. Cela peut être fait en particulier reliant le premier nœud de lecture et le deuxième nœud entre eux, ou bien en reliant le premier nœud de lecture et le deuxième nœud de lecture à la deuxième ligne d'alimentation ou bien en reliant une première borne et une deuxième borne de chacun desdits premier et deuxième inverseurs à la deuxième ligne d'alimentation.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
La figure 1 sert à illustrer une cellule mémoire élémentaire susceptible d'être intégrée à un dispositif mémoire ReRAM suivant un mode de réalisation de la présente invention ;
La figure 2 une matrice de cellules mémoires au sein d'un dispositif mémoire ReRAM suivant un mode de réalisation de la présente invention ;
La figure 3 sert à illustrer des éléments de commande périphériques à un plan matriciel d'un dispositif mémoire ReRAM suivant l'invention ;
La figure 4 sert à illustrer un circuit de lecture de donnée mémorisée dans une cellule ReRAM et tel que mis en œuvre suivant un mode de réalisation de la présente invention ;
Les figures 5A, 5B servent à illustrer respectivement une phase d'attente et une phase de comparaison pour la mise en œuvre d'une opération de lecture de cellule ReRAM telle que mise en œuvre suivant un mode de réalisation de la présente invention ;
La figure 6 sert à illustrer un circuit de lecture tel que mis en œuvre suivant un mode de réalisation de la présente invention et doté de transistors de séparation et de transistors d'isolation disposés en amont d'un amplificateur de détection à verrouillage;
Les figures 7A, 7B, 7C servent à illustrer respectivement une phase d'attente, une phase de décharge partielle et une phase de comparaison réalisées par un circuit de lecture suivant un mode de réalisation de la présente invention pour la mise en œuvre d'une opération de lecture d'une cellule ReRAM ;
La figure 8 sert à illustrer différents signaux mis en œuvre lors de phase d'attente, de décharge partielle et de comparaison d'une opération de lecture d'une cellule ReRAM ;
La figure 9 sert à illustrer un mode de réalisation particulier d'un circuit de commande d'un circuit de lecture de cellule mémoire ReRAM ;
La figure 10 sert à illustrer un autre mode de réalisation particulier d'un circuit de commande permettant de piloter le séquencement de signaux de commande d'un circuit de lecture de cellule mémoire ReRAM tel que mis en œuvre suivant un mode de réalisation de la présente invention ;
La figure 11 sert à illustrer une variante de réalisation du circuit de commande pour laquelle le séquencement de signaux de commande est réglé en fonction d'une mesure de tensions prélevées sur chacune des lignes de bit d'une paire de ligne de bits utilisées pour lire une donnée mémorisée dans une cellule ReRAM ;
La figure 12 sert à illustrer une autre variante de réalisation du circuit de commande ;
La figure 13 sert à illustrer une variante de réalisation du circuit de lecture pour laquelle la réinitialisation de l'amplificateur de détection est réalisée au moyen d'un étage de réinitialisation particulier en reliant entre eux les nœuds de lecture dudit amplificateur ;
Les figures 14A, 14B, 14C servent à illustrer différentes phases de fonctionnement d'un circuit de lecture muni de cet étage de réinitialisation particulier de l'amplificateur de détection ;
La figure 15 sert à illustrer une variante de réalisation d'un étage de réinitialisation d'un amplificateur de détection intégré à un circuit de lecture de mémoire ReRAM ;
La figure 16A sert à illustrer un mode de réalisation particulier dans lequel un élément de mémorisation est prévue en sortie de l'amplificateur de détection à verrouillage afin de mémoriser une donnée en sortie de cet amplificateur de détection à verrouillage avant qu'une réinitialisation de l'amplificateur ne soir effectuée ;
La figure 16B sert à illustrer un autre mode de réalisation particulier avec une variante d'élément de mémorisation prévue en sortie de l'amplificateur de détection à verrouillage lorsque ce dernier est muni d'un interrupteur de réinitialisation entre ses nœuds de lecture ;
La figure 17 sert à illustrer un dispositif mémoire ReRAM selon un mode de réalisation particulier et muni de moyens de repolarisation des lignes de bits ;
La figure 18 sert à illustrer une variante d'agencement d'une cellule mémoire ReRAM susceptible d'être intégrée à une matrice mémoire ReRAM suivant l'invention ;
La figure 19 sert à illustrer un circuit de lecture pour mémoire ReRAM doté d'une paire supplémentaire de transistors d'isolation afin d'effectuer des opérations logiques, en particulier des opérations logiques de type XOR ou NXOR entre une donnée non-volatile mémorisée dans la mémoire ReRAM et une autre donnée, en particulier une donnée de mémoire volatile ;
La figure 20 sert à illustrer un circuit de lecture pour mémoire ReRAM configuré pour mettre en œuvre, ou une lecture normale des opérations logiques, en particulier des opérations logiques de type XOR ou OR ou AND sans paire supplémentaire de transistors d'isolation ;
La figure 21 sert à illustrer un bloc logique de commande permettant de faire commuter le circuit de lecture entre un mode de fonctionnement en lecture simple et au moins un mode de fonctionnement en opération de calcul en mémoire pour lequel ce circuit de lecture est susceptible de participer à la mise en œuvre d'une ou plusieurs opérations logiques ;
La figure 22 sert à illustrer un dispositif mémoire muni du bloc de commande pour piloter le séquencement d'au moins un signal de commande de transistors d'isolation et d'un moyen pour piloter le séquencement du signal de commande d'un étage de réinitialisation ;
La figure 23 sert à illustrer un dispositif mémoire muni du bloc de commande pour piloter le séquencement du signal de commande pour piloter le séquencement d'au moins un signal de commande de transistors d'isolation et d'un autre moyen pour piloter le séquencement du signal de commande d'un étage de réinitialisation ;
La figure 24 sert à illustrer un exemple de réalisation d'un bloc numérique de commande permettant de produire différents signaux de commande de transistors d'isolation du circuit de lecture en fonction d'un mode de fonctionnement sélectionné pour ce circuit de lecture ;
La figure 25 sert à illustrer un exemple de réalisation du dispositif mémoire ReRAM avec des cellules 1T-1R ;
La figure 26 sert à illustrer un exemple de réalisation une variante de réalisation sans transistor d'isolation et pour laquelle dans l'amplificateur de détection un interrupteur de réinitialisation est agencé entre eux les nœuds de lecture ;
Les figures 27A, 27, 27C servent à illustrer différentes phases de fonctionnement de cette variante de réalisation lors d'une opération de lecture ;
La figure 28 sert à illustrer l'évolution de signaux notamment de signaux de contrôle des différentes phases de fonctionnement de cette variante de réalisation ;
La figure 29 sert à illustrer un mode de réalisation particulier de cette variante avec des moyens de repolarisation des lignes de bits ;

En outre, dans la description ci-après, des termes qui dépendent de l'orientation du dispositif comme par exemple « verticale », « horizontale », s'appliquent en considérant que le dispositif est orienté de la façon illustrée dans les figures.

Des parties identiques, similaires ou équivalentes des différentes figures portent les mêmes références numériques de façon à faciliter le passage d'une figure à l'autre.

### EXPOSÉ DÉTAILLÉ DE MODES DE RÉALISATION PARTICULIERS

En remarque liminaire, dans la présente demande on utilisera le référentiel des niveaux logiques « 0 » ou « 1 » pour signifier respectivement, par raccourci, un potentiel bas, par exemple égal à une masse gnd, et un potentiel haut, par exemple égal à une tension d'alimentation Vdd.

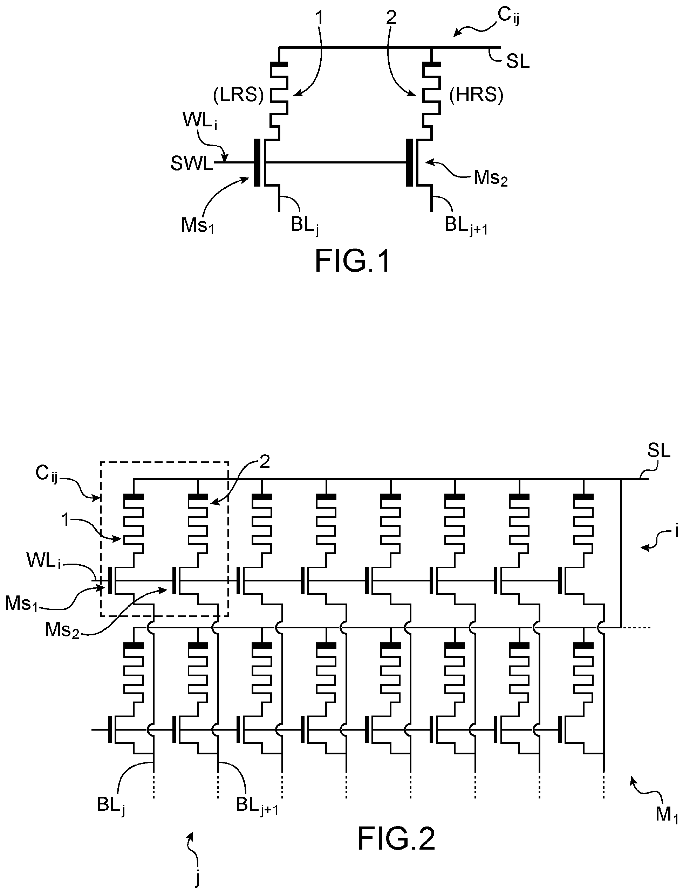

On se réfère à présent à la figure 1 donnant une structure de cellule Cᵢⱼ mémoire élémentaire susceptible d'être intégrée à un dispositif mémoire ReRAM suivant l'invention, un tel dispositif comportant typiquement une matrice de telles cellules.

La cellule Cᵢⱼ est prévue pour conserver une donnée binaire et a un agencement conventionnel, avec, dans cet exemple, deux éléments résistifs 1, 2, de résistivité variable entre deux niveaux de résistivité LRS et HRS, et imposés par des opérations d'écriture, le niveau imposé au premier élément résistif 1, dans l'exemple illustré noté LRS, étant distinct de celui imposé au deuxième élément résistif 2 et qui, dans l'exemple illustré, est noté HRS. Les éléments résistifs 1, 2 d'une même cellule sont ainsi écrits en opposition d'état.

Les éléments résistifs 1, 2 sont chacun munis d'une électrode couplée à une ligne dite « de source » SL et d'une autre électrode couplée à un transistor de sélection M_{S1}, M_{S2}. Selon un exemple de réalisation particulier, les éléments résistifs 1, 2 sont de type OxRAM.

Dans une cellule élémentaire, deux transistors de sélection M_{S1}, M_{S2}, dont les grilles sont commandées par un signal véhiculé par une même ligne de mot WLᵢ permettent ainsi, alternativement de coupler ou de découpler les éléments résistifs 1, 2, respectivement à une première ligne de bit BLⱼ et à une deuxième ligne de bit BLⱼ₊₁. Le terme "couplé" est utilisé tout au long de la présente demande pour désigner une liaison électrique directe ou une liaison établie via un ou plusieurs composants intermédiaires (résistance(s), transistor(s), etc.).

Dans cet exemple, les cellules élémentaires sont ainsi de type « 2T-2R » avec deux éléments résistifs 1, 2 et deux transistors de sélection M_{S1}, M_{S2} par cellule.

Dans une matrice M₁ de cellules, dont une vue partielle est donnée à titre d'exemple sur la figure 2, une même première ligne d'alimentation appelée ligne de source SL est typiquement partagée par l'ensemble des cellules, tandis que les cellules d'une même rangée i horizontale, autrement dit une même ligne de cellules, partagent une même ligne de mot WLᵢ et que les cellules d'une même rangée verticale j, autrement dit une colonne de cellules, partagent une même paire de lignes bits BLⱼ, BLⱼ₊₁.

On notera que la matrice de cellules mémoire peut être accéder en lecture ou en écriture (incluant l'effacement utile pour certaines technologies de mémoire résistive). On s'intéresse dans la présente invention plus particulièrement au mode lecture. En mode lecture, la ligne de source SL est dans les exemples décrits en permanence reliée à un même potentiel d'alimentation. Dans l'exemple en cours de description, ce potentiel d'alimentation est « haut », ici égal à VDD.

Lors d'un mode d'écriture, la ligne de source SL peut par exemple être reliée à la masse GND par un circuit 10 de pilotage de ligne de source.

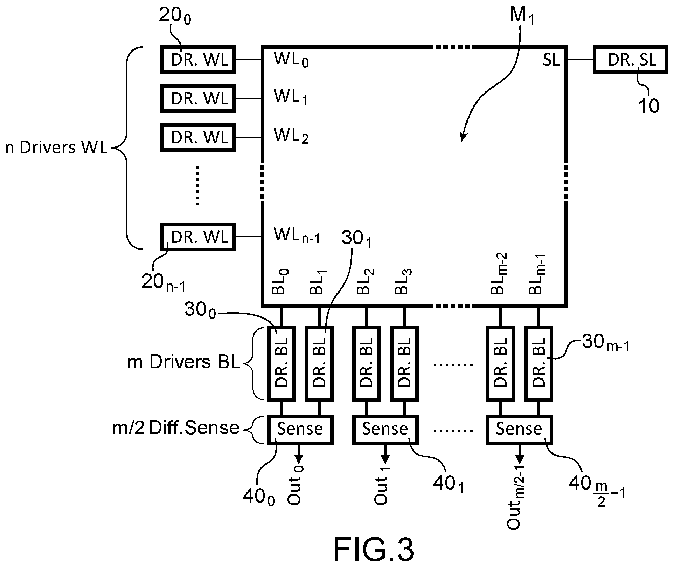

La matrice M₁ est également associée, comme illustré sur la figure 3, à des circuits de pilotage de ligne de mot, par exemple un par ligne de la matrice M₁, de sorte que pour une matrice de n lignes, le dispositif mémoire comporte n circuits 200₀,...,20ₙ₋₁ de pilotage de lignes de mot.

Le dispositif mémoire est également typiquement doté de circuits de pilotage de ligne de bits, par exemple un circuit de pilotage 30₀,...,30ₘ₋₁ par ligne de bit, de sorte que pour une matrice de m/2 colonnes de cellules et deux lignes de bit par colonne, le dispositif mémoire comporte m circuits 30₀,...,30ₘ₋₁ de pilotage de lignes de bits, chacun permettant de sélectionner les cellules d'une même colonne de cellules.

En périphérie de la matrice, et en particulier en pied de chaque paire de colonnes, on prévoit un circuit de lecture 40₀,...,40_{m/2-1} pour permettre de traduire en une donnée binaire sur la sortie respective OUT_{0,...,} OUT _{m/2-1} d'un tel circuit de lecture les états résistifs des éléments résistifs 1, 2 d'une cellule mémoire ReRAM à laquelle on accède en lecture.

Afin d'améliorer les opérations de lecture, et en particulier pour réduire la consommation dynamique lors des opérations de lecture, les circuits de lecture 40₀, 40_{1,...,} 40_{m/2-1} couplés chacun à une paire BL₀-BL_{1, ... ,} BLₘ₋₂-BLₘ₋₁ de lignes de bits sont ici prévus avec un agencement particulier.

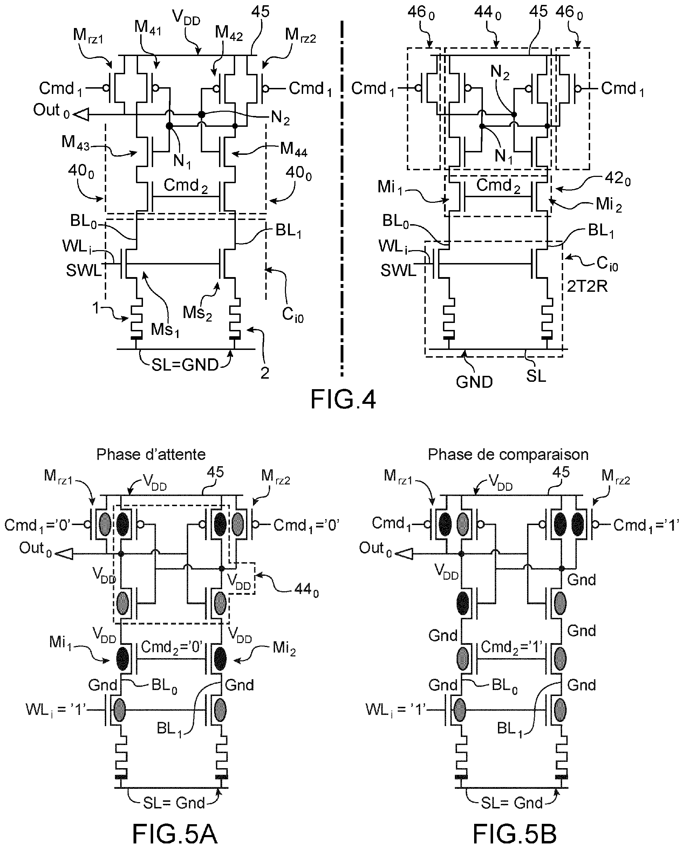

Un exemple de réalisation d'un circuit de lecture 40₀ est donné sur la figure 4, ici couplé à une cellule Cᵢ₀ d'une paire de colonnes auxquelles ce circuit de lecture 40₀ est associé, et dont on souhaite ici lire la donnée binaire mémorisée. Le circuit de lecture 40₀ est par ailleurs apte à lire les données binaires respectives de cellules appartenant à la même paire de colonnes que la cellule Cᵢ₀. Dans cet exemple de réalisation la cellule Cᵢ₀ est couplée à une ligne de source SL autrement dit une ligne d'alimentation, ici mis à un potentiel bas par exemple égal au potentiel de référence ou masse GND.

Le circuit 40₀ de lecture est pourvu d'un étage 44₀ formant un amplificateur de détection (« sense amplifier » selon la terminologie anglo-saxonne plus couramment utilisée) également appelé amplificateur de lecture, de type à verrouillage ou formant un verrou (« latch » selon la terminologie anglo-saxonne plus couramment utilisée).

L'amplificateur de détection 44₀ est ici doté de transistors M₄₁, M₄₃ formant un premier inverseur et de transistors M₄₂, M₄₄ formant un deuxième inverseur, le premier inverseur et le deuxième inverseur étant connectés de façon croisée i.e. avec une entrée du premier inverseur correspondant à la sortie du deuxième inverseur et la sortie du deuxième inverseur correspondant à l'entrée du premier inverseur. L'amplificateur de détection 44₀ est ainsi pourvu d'un premier nœud N₁ de lecture reliant l'entrée du premier inverseur et la sortie du deuxième inverseur, tandis qu'un deuxième nœud de lecture N₂ relie l'entrée du deuxième inverseur et la sortie du premier inverseur.

L'amplificateur de détection 44₀ est en outre relié à une deuxième ligne d'alimentation 45 mise à un potentiel différent de celui de la première ligne d'alimentation ou ligne de source SL. Typiquement, la deuxième ligne d'alimentation 45 est mise à un potentiel haut lorsque la première ligne d'alimentation ou ligne de source SL correspondant est mis à un potentiel bas et inversement. Dans l'exemple de réalisation particulier illustré la deuxième ligne d'alimentation 45 est mise à un potentiel haut correspondant à la tension d'alimentation VDD.

Chaque inverseur de l'amplificateur de détection 40₀ constitue une branche reliée d'une part à la deuxième ligne d'alimentation et d'autre part à une ligne de bits, les premier et deuxième inverseurs constituent ainsi des première et deuxième branches respectivement reliés aux lignes de bits BL₀ et BL₁.

Lorsqu'on effectue une opération de lecture sur la cellule Cᵢ₀, la différence de résistance entre l'élément résistif 1, et l'élément résistif 2 entraine un déséquilibre de courant entre les deux branches de l'amplificateur 44₀ reliées chacune à un de ces éléments résistifs, et entre deux nœuds de lecture N₁, N₂ respectifs de ces branches. Si les deux nœuds N1 et N2 sont tous deux initialement au même potentiel, par exemple égal à la deuxième ligne d'alimentation 45, ce déséquilibre a pour conséquence que l'on atteint plus rapidement la tension de seuil d'un des transistors M₄₁ ou M₄₂, relié à la branche de plus forte résistance. Dans cet exemple, où les transistors M₄₁, M₄₂, sont de type PMOS et reliés à la tension d'alimentation VDD, cela entraine une mise à VDD du nœud N1 ou N2 de la branche reliée à la résistance HRS, et l'autre nœud N2 ou N1 de l'autre branche a un potentiel sensiblement égal à celui de la ligne de bits reliée à cette autre branche.

L'amplificateur de lecture a dès lors « basculé » dans un état qui s'auto-entretient tant que les nœuds de lecture N₁, N₂ ne sont pas réinitialisés. Le potentiel respectif des nœuds de lecture N₁, N₂ est figé et on dit que l'amplificateur de détection 44₀ se trouve dans un état de verrouillage.

Dans l'exemple de réalisation particulier illustré sur la figure 4, on prend la sortie OUT₀ au deuxième nœud N₂ de lecture de l'amplificateur de détection 44₀.

L'amplificateur de détection 44₀ est associé à un étage 46₀ de réinitialisation des nœuds de lecture N₁, N₂. Cet étage 46₀ est muni d'au moins un premier élément interrupteur, dans cet exemple sous forme de deux transistors de réinitialisation Mrz₁, Mrz₂ également appelés transistors de remise à zéro, notamment prévus pour permettre de réinitialiser les nœuds de lecture, à un même potentiel et sortir ainsi l'amplificateur de détection 44₀ de son état verrouillé.

Chaque transistor de réinitialisation Mrz₁, Mrz₂ permet ainsi alternativement, en fonction de l'état bloqué ou passant dans lequel il peut être placé par le biais d'un premier signal de commande Cmd₁ commun et appliqué sur la grille de deux transistors Mrz₁, Mrz₂, d'isoler ou de connecter les nœuds N₁, N₂ à la deuxième ligne d'alimentation 45, dans cet exemple de réalisation particulier une ligne d'alimentation mise à un potentiel « haut », ici correspondant au potentiel d'alimentation VDD.

L'état de ce premier signal de commande Cmd₁ est également amené à être modifié au cours d'une opération de lecture effectuée sur la cellule Cᵢ₀.

Le circuit 40₀ de lecture a ici pour particularité de comporter un étage 42₀ dit « d'isolation » entre la paire de lignes de bits BL₀, BL₁ et l'étage 44₀ formant l'amplificateur de détection (« sense amplifier » selon la terminologie anglo-saxonne) à verrouillage (« latch » selon la terminologie anglo-saxonne).

L'étage d'isolation 42₀ comporte dans cet exemple deux transistors Mi₁, Mi₂ d'isolation, un premier transistor d'isolation Mi₁ étant disposé entre l'amplificateur de détection 44₀ et une première ligne de bit BL₀, un deuxième transistor d'isolation Mi₂ étant disposé entre l'amplificateur de détection 44₀ et une deuxième ligne de bit BL₁.

Les transistors d'isolation Mi₁, Mi₂ permettent ainsi alternativement, en fonction de leur état bloqué ou passant, commandé par un deuxième signal de commande Cmd₂ appliqué sur leur grille, d'isoler les lignes de bits BL₀, BL₁ de l'amplificateur de détection 44₀ ou de connecter les lignes de bits BL₀, BL₁ à l'amplificateur de détection 44₀. L'état du deuxième signal de commande Cmd₂ est lui-même piloté par un circuit de commande du circuit de lecture et est amené à être modifié lors d'une opération de lecture effectuée sur la cellule Cᵢ₀, afin de modifier l'état de conduction des transistors d'isolation Mi₁, Mi₂ lors de cette opération de lecture. Les transistors d'isolation ont ainsi ici une fonction de transistors de couplage permettant alternativement de coupler et découpler le circuit de lecture d'éléments situés en amont.

Un exemple d'opération de lecture réalisée à l'aide d'un tel circuit de lecture 40₀ va à présent être donné en liaison avec les figures 5A-5B.

L'opération de lecture est réalisée dans cet exemple en deux phases et comporte typiquement une phase d'attente et une phase de comparaison.

Lors d'une « phase d'attente », (figure 5A), les potentiels aux nœuds N₁, N₂ de l'amplificateur 44₀ sont réinitialisés et ainsi mis, ou pré-chargés, à une même valeur. Pour cela, le premier signal de commande Cmd₁ commun au premier transistor de réinitialisation Mrz₁ et au deuxième transistor de réinitialisation Mrz₂, est placé, dans cet exemple où les transistors Mrz₁, Mrz₂ sont de type PMOS, dans un état correspondant à un '0', de sorte à rendre passants les transistors Mrz₁, Mrz₂, et relier les nœuds N₁, N₂ à un même potentiel, ici un potentiel d'alimentation égal à VDD.

Lors de cette phase d'attente, les transistors de sélection Ms₁, Ms₂ sont activés par le biais d'une ligne de mot WLᵢ mise par exemple dans un état '1', en particulier lorsqu'ils sont de type NMOS.

Le signal Cmd₂ de commande du premier transistor d'isolation Mi₁ et du deuxième transistor d'isolation Mi₂, est mis dans un état, dans cet exemple où les transistors d'isolation Mi₁, Mi₂ sont de type NMOS correspondant à un niveau logique '0', de sorte à rendre bloqués les transistors Mi₁, Mi₂. Les lignes de bits BL₀, BL₁ sont ainsi déconnectées et isolées de l'amplificateur de détection 44₀. On évite ainsi, lors de cette étape, une décharge des lignes de bits BL₀, BL₁ qui sont alors reliées à un même premier potentiel, ici égal à la masse GND autrement dit à un potentiel égal ou sensiblement égal à celui de la ligne de source SL. Dans cet exemple de réalisation plutôt qu'un circuit spécifique de pré-charge, c'est la ligne de source SL qui permet d'imposer le premier potentiel GND sur les lignes de bits BL₀, BL₁.

On notera que par convention, on appelle précharge d'une ligne de bits l'opération consistant à maintenir ou à amener une ligne de bits à un potentiel sensiblement égal à celui présent sur la première ligne d'alimentation, autrement dit celui présent sur la ligne de source. Par suite, on appelle décharge d'une ligne de bits, une opération consistant à éloigner son potentiel de son niveau de pré-charge, en le rapprochant du potentiel présent sur la deuxième ligne d'alimentation. Ainsi dans les exemples des figures 5A et 5B, on parlera de pré-charge d'une ligne de bit quand on maintient ou rapproche la tension de la ligne de bit vers la tension GND et on parlera de décharge quand on élèvera le potentiel de la ligne de bit vers la tension Vdd. Pour d'autres exemples de réalisation « inversés », pour lesquels la ligne de source est à Vdd, la convention sera donc opposée.

Après la phase d'attente, lors d'une phase dite « de comparaison » (figure 5B), le premier signal de commande Cmd₁ commun au premier transistor de réinitialisation Mrz₁ et au deuxième transistor de réinitialisation Mrz₂, est placé dans un état, différent de celui de la phase d'attente et de réinitialisation précédente, correspondant à un '1' dans cet exemple, de sorte à bloquer les transistors Mrz₁, Mrz₂, et déconnecter ainsi les nœuds N₁, N₂ de lecture de la ligne d'alimentation 45 pour qu'ils puissent adopter des potentiels respectifs distincts.

Lors de cette phase de comparaison, les transistors de sélection Ms₁, Ms₂ sont activés toujours par le biais d'une ligne de mot WLᵢ qui est dans l'état correspondant ici à un '1' logique. Lors de la phase de comparaison, le signal Cmd₂ de commande du premier transistor d'isolation Mi₁ et du deuxième transistor d'isolation Mi₂, est quant à lui mis dans un état différent de celui de la phase d'attente. Dans cet exemple, où les transistors d'isolation Mi₁, Mi₂ sont de type NMOS, on applique un signal Cmd₂='1', de sorte à rendre passants les transistors d'isolation Mi₁, Mi₂. Les lignes de bits BL₀, BL₁ sont ainsi connectées à l'amplificateur de détection 44₀. Lorsque les transistors d'isolation Mi₁, Mi₂ sont mis en conduction, chaque branche de l'ampli 440 est reliée à une résistance de la cellule Cᵢ₀. Un courant s'établit dans chacune des branches jusqu'à ce que l'amplificateur se verrouille. Le verrouillage étant relativement rapide, les lignes de bit BL₀, BL₁ se déchargent très peu et leur potentiel reste proche de la masse GND dans cet exemple.

Contrairement à un fonctionnement des dispositifs de l'état de l'art précités pour lesquels les lignes de bit subissent une décharge quasi intégrale lors de l'opération de comparaison on évite ici une décharge-charge à pleine échelle des lignes de bits entre la masse GND et la tension d'alimentation Vdd. Un tel mode de fonctionnement permet ainsi de réduire l'amplitude de la charge-décharge des lignes de bits BL₀, BL₁ et donc d'améliorer la consommation dynamique de la lecture, cette consommation étant alors principalement due à celle de l'amplificateur de détection. Cet avantage est lié au fait que le niveau de précharge des lignes de bit correspond au niveau de tension appliqué aux mémoires résistives des cellules mémoire du côté opposé aux lignes de bit. Autrement dit, préalablement à une opération de comparaison, les mémoires résistives, une fois la ligne de mots (WLi) activée, voient à leurs bornes une tension relativement faible, qui peut par exemple correspondre à quelques pourcents, 5 à 10%, de la tension entre les deux lignes d'alimentation, gnd et Vdd. Cette tension aux bornes des mémoires résistives augmente très légèrement le temps que l'amplificateur se verrouille pour se stabiliser et diminuer une fois l'amplificateur verrouillé.

On note, que dans l'exemple de fonctionnement qui vient d'être décrit, les signaux Cmd₁, Cmd₂ sont modifiés concomitamment. Autrement dit la réinitialisation de l'amplificateur 440 est interrompu au moment où on relit les branches de l'amplificateur aux lignes de bit. En pratique, ce mode de fonctionnement peut induire d'éventuelles erreurs de lecture si les lignes de bit présentent une capacité élevée car il se peut que l'amplificateur se verrouille sur des courants de décharge des capacités respectives des lignes de bit, et non sur les niveaux de résistance des mémoires résistives. Une solution à ce problème est donnée infra.

Avec un mode de fonctionnement tel que décrit précédemment, on ne modifie pas la polarisation de la ligne de mot WLᵢ entre la phase d'attente et la phase de comparaison. L'état d'un signal SWL appliqué sur la ligne de mot WLᵢ n'est modifié, et par exemple mis à un état '0', qu'après l'achèvement de la phase de comparaison et de l'opération de lecture.

Les transistors d'isolation Mi₁, Mi₂ décrits précédemment sont dans cet exemple distincts d'autres transistors appelés transistors « de séparation », et que l'on peut utiliser pour isoler le circuit de lecture 40₀ lors d'opérations d'écritures effectuées dans la matrice M₁.

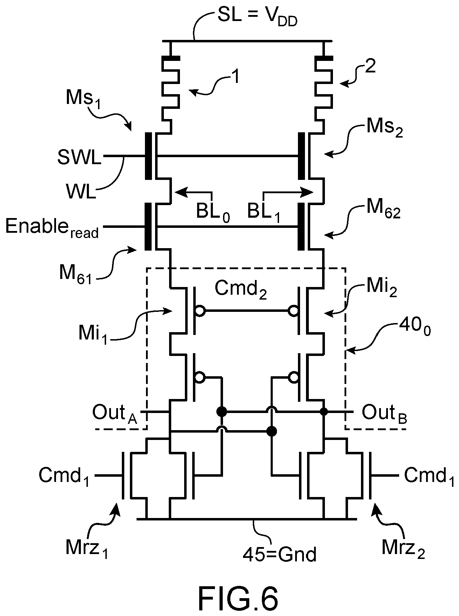

Ainsi, afin de protéger les transistors du circuit de lecture 40₀ lors des opérations d'écriture, on peut prévoir en pied de colonne, comme dans l'exemple de réalisation illustré sur la figure 6, des transistors de séparation M₆₁, M₆₂ agencés respectivement entre la première ligne de bit BL₀ et le premier transistor d'isolation Mi₁ et entre la deuxième ligne de bit BL₁ et le deuxième transistor d'isolation Mi₂. L'état passant ou bloqué des transistors de séparation M₆₁, M₆₂ est commandé par le biais d'un signal de validation de lecture Enable_{read} appliqué sur leur grille. Les transistors de séparation ont ainsi ici également une fonction de transistors de couplage permettant alternativement de coupler et découpler le circuit de lecture d'éléments situés en amont.

Les transistors de séparation M₆₁, M₆₂ sont activés, autrement dit rendus « passants » lors des opérations de lecture tandis que lors d'opérations d'écriture, les transistors de séparation M₆₁, M₆₂ sont rendus bloqués afin d'isoler le circuit de lecture de la cellule dans laquelle on écrit.

Typiquement, les transistors de séparation M₆₁, M₆₂ de même que les transistors de sélection Mₛ₁, Mₛ₂ sont prévus avec un diélectrique de grille plus épais que celui des transistors du circuit de lecture 40₀, afin de pouvoir être soumis à des niveaux de tension importants tandis que les transistors de l'amplificateur de détection et les transistors d'isolation Mi₁, Mi₂, sont prévus avec un diélectrique de grille d'épaisseur plus faible. Cela permet en pratique, lors de la lecture, d'éviter une perte d'information dans les cellules mémoire par d'éventuelles écritures non souhaitées et permet en outre de limiter la consommation.

Lors d'une opération de lecture, le signal de validation de lecture Enable_{read} est constamment maintenu dans le même état, par exemple Enable_{read} = '1' lorsque les transistors de séparation M₆₁, M₆₂ sont comme sur la figure 6 de type NMOS.

Selon une variante non représentée, les fonctions respectives d'isolation, par les transistors Mi₁, Mi₂, et de séparation, par les transistors M₆₁, M₆₂, pourraient être réalisées par une même paire de transistors. Ainsi, on pourrait par exemple uniquement conserver les transistors M₆₁, M₆₂ et les rendre conducteurs quand on est en mode lecture (par opposition à d'autres types d'opérations sur la matrice, telles que l'écriture, l'effacement des cellules mémoires) et quand, toujours dans un mode de lecture, on souhaite lever l'isolation entre la matrice de cellules mémoire et l'amplificateur différentiel de détection 44₀. On souhaite notamment lever la fonction d'isolation lorsque l'on réalise une comparaison et dans la plupart des modes de réalisation décrits lors de la phase de décharge partielle préalable à la phase de comparaison comme cela est décrit plus en détails dans les exemples suivants.

La figure 6 permet également d'illustrer une autre possibilité de mise en œuvre du dispositif, pour laquelle la ligne de source SL est cette fois une ligne d'alimentation mise à un potentiel haut correspondant ici à la tension d'alimentation VDD lorsqu'on effectue des opérations de lecture ou d'écriture, tandis que l'amplificateur de détection 40₀ est ici relié à une ligne d'alimentation 45, mise à un potentiel bas, inférieur au potentiel haut et qui correspond ici au potentiel de référence GND. Pour cette variante, les transistors de réinitialisation Mrz₁, Mrz₂ sont cette fois de type NMOS, tandis que les transistors d'isolation Mi₁, Mi₂ sont de type PMOS.

La forte capacité des lignes de bits BL₀, BL₁ peut poser problème, en particulier lorsque le signal de commande Cmd₂ des transistors d'isolation Mi₁, Mi₂ est modifié et que les lignes de bits BL₀, BL₁ se retrouvent connectées à l'amplificateur de détection 44₀. De cette mise en connexion peut en effet éventuellement et dans certains cas découler une décharge des lignes de bits BL₀, BL₁ vers l'amplificateur de détection 44₀ qui n'est pas systématiquement corrélée avec les états respectifs des éléments résistifs de la cellule que l'on souhaite lire et qui peut avoir tendance à faire basculer la sortie de l'amplificateur de détection 44₀ sans que cette sortie ne soit représentative de la donnée binaire stockée en mémoire de la donnée lue.

Pour pallier ce problème et améliorer la fiabilité de lecture, une solution peut consister à mettre en œuvre des séquencements différents entre le séquencement du signal de commande Cmd₂ des transistors d'isolation Mi₁, Mi₂ et le séquencement du signal de commande Cmd₁ des transistors de réinitialisation Mrz₁, Mrz₂.

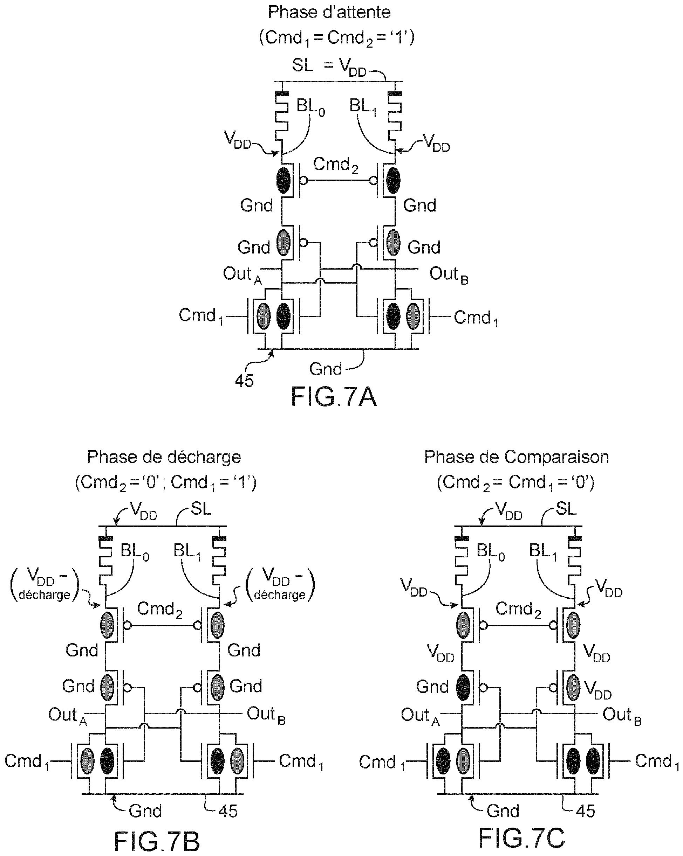

Une opération de lecture suivant cette variante est illustrée sur les figures 7A-7C.

La phase d'attente préalable (illustrée sur la figure 7A) est semblable à celle décrite précédemment, avec un signal de commande Cmd₂, permettant de déconnecter, ou autrement dit d'isoler, les lignes de bits BL₀, BL₁ par rapport au circuit de lecture 40₀. Le signal Cmd2 est alors dans un état '1' afin de mettre les transistors d'isolation Mi₁, Mi₂, dans cet exemple de type PMOS, dans un état bloqué. On réalise alors une précharge de ses lignes de bits BL₀, BL₁ à un potentiel égal ou sensiblement égal à celui de la ligne de source SL, soit par l'intermédiaire des éléments résistifs comme précédemment décrit, soit par d'autres dispositifs détaillés infra.

De même, pour permettre la réinitialisation de l'amplificateur de détection 44₀ on met les nœuds de lecture N₁, N₂ à un même potentiel ici correspondant à la masse GND. Ainsi, dans l'exemple de réalisation illustré sur la figure 7A, le signal de commande Cmd₁ est mis à '1' afin de mettre les transistors de réinitialisation Mrz₁, Mrz₂, dans cet exemple de type NMOS, dans un état passant.

Ensuite, un cycle en deux phases est effectué.

Selon une phase dite de « décharge partielle » (illustrée sur la figure 7B), on active les transistors d'isolation Mi₁, Mi₂ via le signal de commande Cmd₂ ce qui déclenche la décharge des lignes de bits, tandis qu'on maintient les transistors de réinitialisation Mrz₁, Mrz₂ passants. Une décharge dirigée vers la masse à laquelle l'amplificateur de détection 44₀ est ici reliée par l'intermédiaire de la ligne d'alimentation 45, est réalisée à travers les transistors de réinitialisation Mrz₁, Mrz₂ tout en maintenant la réinitialisation de l'amplificateur de détection 44₀ afin qu'il ne commute pas dans cette étape.

Dans l'exemple de réalisation illustré sur la figure 7B, les signaux de commande Cmd₁ et Cmd₂ sont respectivement mis à '1' et à '0' afin de mettre les transistors d'isolation Mi₁, Mi₂ et les transistors de réinitialisation Mrz₁, Mrz₂ dans un état passant.

Puis, après un temps relativement court, lorsque la décharge parasite des lignes de bit a été évacuée et que les courants sont enfin fonction des valeurs des éléments résistifs, on désactive les transistors de réinitialisation Mrz₁, Mrz₂ pour permettre ainsi la commutation de l'amplificateur de détection conformément à la donnée binaire contenue dans la cellule 2T-2R sélectionnée.

On notera que cette opération de décharge partielle des lignes de bit vise à décharger légèrement les lignes de bit de sorte à permettre l'établissement d'une tension minimum aux bornes des éléments résistifs permettant d'induire un passage de courants dans les résistances qui deviennent significatifs par rapport au courant d'auto-décharge des lignes de bit et en outre qui permettent d'obtenir des courants relatifs dans les mémoires résistives suffisamment différents l'un de l'autre pour pouvoir passer à l'étape suivante de comparaison.

Ainsi, après la phase de décharge partielle on effectue la phase dite de « comparaison » (illustrée sur la figure 7C). Le signal de commande Cmd₂ des transistors d'isolation Mi₁, Mi₂ est maintenu dans un état (dans l'exemple de réalisation illustré maintenu à '0') de sorte à maintenir passants ces transistors Mi₁, Mi₂, tandis que l'état du signal de commande Cmd₁ des transistors de réinitialisation Mrz₁, Mrz₂ est modifié (dans l'exemple de réalisation illustré mis à '0') de sorte à rendre bloqués les transistors de réinitialisation Mrz₁, Mrz₂ et permettre ainsi que les nœuds de lecture N₁, N₂ puissent évoluer vers des potentiels respectifs distincts.

Le réglage de la durée de la phase de décharge et par conséquent le délai entre l'activation des transistors d'isolation et la désactivation des transistors de réinitialisation est effectué de manière à optimiser l'efficacité énergétique de l'opération de lecture, notamment de manière à limiter la décharge partielle des lignes de bit au minimum.

Là encore, contrairement à un fonctionnement conventionnel, on n'effectue pas une décharge des lignes de bits BL₀, BL₁ de la tension d'alimentation de VDD jusqu'à la Masse GND. Un gain en consommation est ainsi obtenu et l'on réduit la consommation dynamique en lecture.

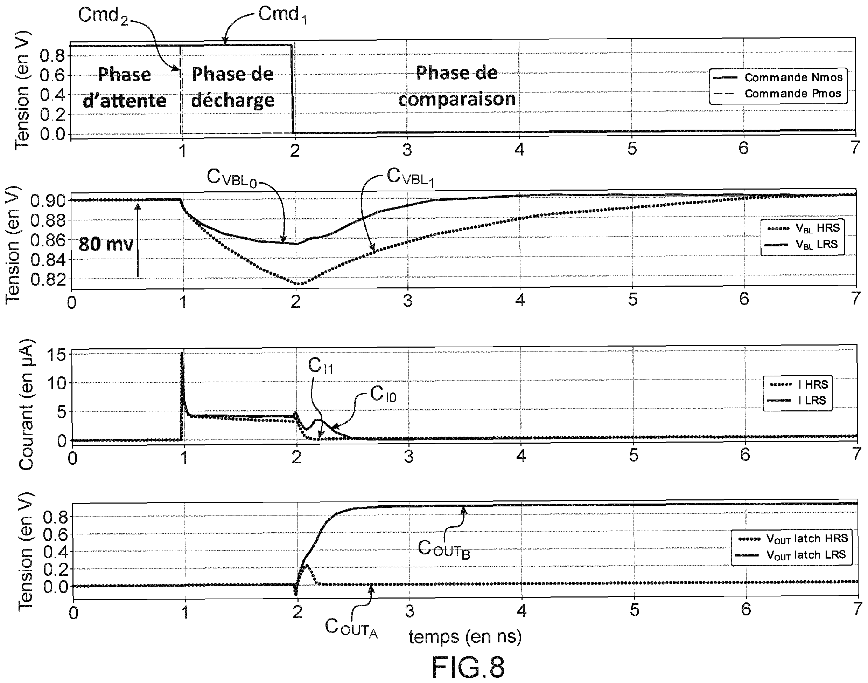

Sur la figure 8, des courbes d'évolution de différents signaux mis en jeu lors d'une simulation d'opération de lecture sont donnés, pour une matrice mémoire dotée de 64 lignes et par conséquent 64 lignes de mots WL avec, dans cet exemple, un délai entre le début et la fin de la phase de décharge partielle fixé à 1 ns, et des transistors dans une technologie FDSOI (« Fully Depleted Silicon On Insulator » ou silicium sur isolant totalement déplété) de 28 nm de longueur de grille.

Les courbes C_{cmd1}, C_{cmd2} sont représentatives respectivement du premier signal de commande cmd1 des transistors de réinitialisation Mrz₁, Mrz₂, et du premier signal de commande cmd2 des transistors d'isolation Mi₁, Mi₂, tandis que les courbes Cv_{BL0}, Cv_{BL1} servent à illustrer respectivement la tension sur la première ligne de bit BL₀, dans cet exemple reliée à un élément résistif au niveau HRS, la tension sur la deuxième ligne de bit BL₁, dans cet exemple reliée à un élément résistif au niveau LRS. Les courbes C_{IBL0}, C_{IBL1} servent à illustrer respectivement l'évolution du courant sur la première ligne de bit BL₀, et celle du courant sur la deuxième ligne de bit BL₁, tandis que les courbes CoutA, CoutB donnent l'évolution des potentiels respectifs des nœuds N₂, N₁.

On peut constater qu'avec un tel délai, une décharge partielle des lignes de bits BL de l'ordre de 80 mV est réalisée, pour une décharge à pleine échelle de 0,9 V soit moins de 10% de la tension d'alimentation du circuit.

En simulation à l'aide de l'outil Monte Carlo, on obtient une consommation totale (en prenant en compte des circuits de commande des lignes de bits et des lignes de mots WL, le chargement des lignes de mot WL, la génération du délai) par bit/lu de l'ordre de 30 fJ. Cela est comparable avec une SRAM de même technologie et mieux que l'état de l'art des circuits de mémoire à base de mémoires résistives susmentionnés, en pouvant diviser par deux, voire par trois l'ordre de grandeur de la consommation en lecture.

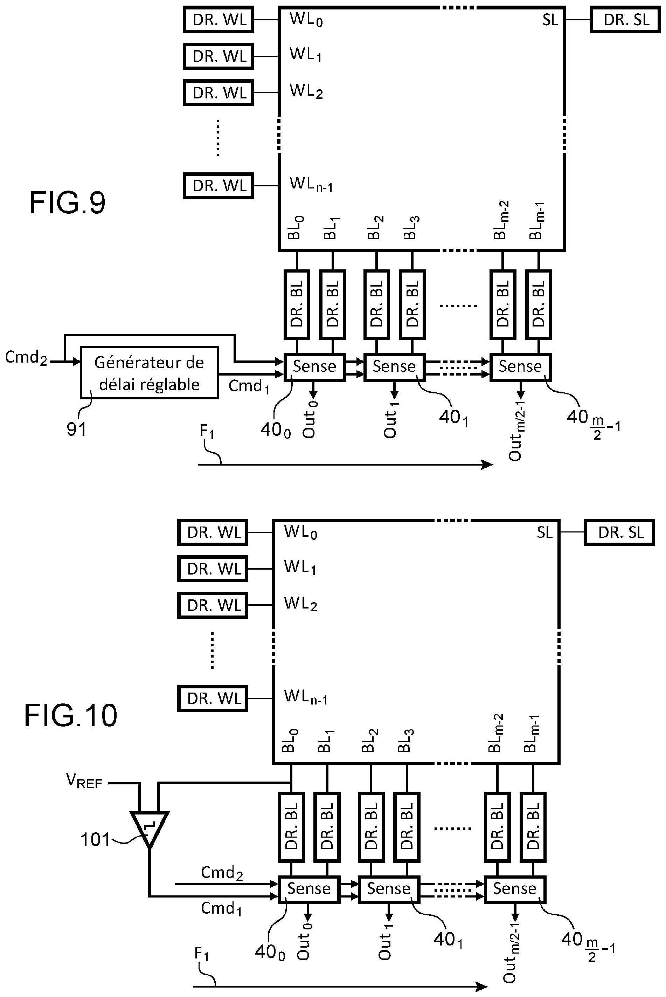

Dans l'exemple de réalisation illustré sur la figure 9, un circuit de commande permettant de produire le signal de commande Cmd₁ de l'étage de réinitialisation et le signal de commande Cmd₂ des transistors d'isolation Mi₁, Mi₂ est muni d'un générateur 91 de délai réglable qui reçoit en entrée le signal de commande Cmd₂ et produit en sortie le signal de commande Cmd₁ correspondant ici au signal Cmd₂ retardé d'un délai prédéterminé.

Le générateur 91 de délai réglable peut être formé par exemple d'une succession d'inverseurs à laquelle on associe un multiplexeur. Le réglage du délai peut être effectué par le biais d'un mot de configuration, le délai étant, dans ce cas, un délai choisi parmi un ensemble de délais prédéterminés en fonction des valeurs des bits du mot de configuration.

Les signaux de commande Cmd₁, Cmd₂ sont propagés d'un circuit de lecture 40₀ à l'autre 40₁ de la pluralité de circuits de lecture 40_{0, ...,} 40(_{m/2)-1} situés en pieds de colonne et couplés chacun à une paire de lignes de bits BL₀, BL₁ (resp. BL₂, BL₃...), selon un sens de propagation typiquement tel que celui représenté de manière schématique par une flèche F₁ sur la figure 9.

Selon une variante de réalisation, lors d'une opération de lecture, on peut déclencher la fin de la phase de décharge partielle en fonction d'une comparaison entre un niveau de tension mesuré sur au moins une ligne de bits, en particulier sur l'une ou l'autre des lignes de bits BL₀, BL₁ ou chacune des lignes de bits BL₀, BL₁ couplées à une cellule que l'on souhaite lire et une tension de référence prédéterminée.

Dans l'exemple de réalisation particulier illustré sur la figure 10, on utilise comme tension mesurée indicatrice d'une décharge partielle suffisante des lignes de bits, une tension V_{BL0} d'une ligne de bit BL₀. Lorsque la tension V_{BL0} atteint un seuil de tension Vref, l'état du premier signal de commande Cmd₁ est modifié.

Comme on le voit sur les courbes C_{VBL0}, C_{VBL1} de simulation plus haut, les tensions des lignes de bits BL₀, BL₁ chutent au fur et à mesure de la décharge partielle de leur capacité. Cette chute correspond à un moment à la formation d'un courant à travers les éléments résistifs 1, 2. Dans l'exemple illustré, plus la tension de ligne de bit VBL est faible plus le courant passant dans l'amplificateur de détection 44₀ est représentatif des valeurs de résistance de la cellule ReRAM et donc plus l'opération de lecture est fiable.

On déclenche dans cet exemple le changement d'état du premier signal de commande Cmd₁ permettant de bloquer les transistors de réinitialisation en utilisant le signal de sortie d'un comparateur 101 dont une entrée reçoit la tension V_{BL0} d'une ligne de bit BL₀. La tension de référence Vref qui sert de référence peut être déterminée en tenant compte de paramètres de variabilité technologique, d'effets thermiques, de décalages (« mismatch ») entre performances des composants.

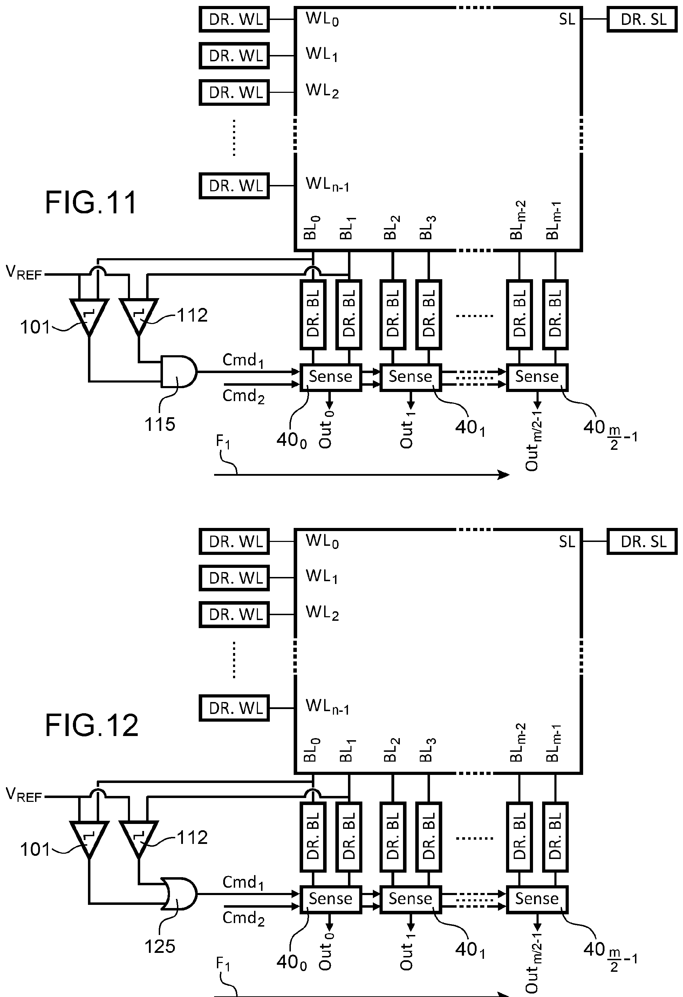

Dans un autre exemple de réalisation particulier illustré sur la figure 11, on utilise comme tension mesurée indicatrice d'une décharge suffisante des lignes de bits, à la fois une tension V_{BL0} de la première ligne de bit BL₀, et une tension V_{BL1} de la deuxième de bit BL₂.

On déclenche alors le changement d'état du signal de commande Cmd₁ de l'étage de réinitialisation en utilisant cette fois un premier comparateur 101 pour comparer une entrée recevant la tension V_{BL0} d'une première ligne de bit BL₀ et la tension de référence V_{ref}, et un deuxième comparateur 112 pour comparer une entrée recevant la tension V_{BL1} de la deuxième ligne de bit BL₁ et la tension de référence V_{ref}. Le signal de commande Cmd₁ de l'étage de réinitialisation peut être alors produit en sortie d'un bloc logique, dans cet exemple une porte 115, réalisant une fonction ET (« AND » selon la terminologie anglo-saxonne) entre une sortie du premier comparateur 101 et une sortie du deuxième comparateur 112. La durée de la phase de décharge est ainsi ajustée en fonction de la durée la plus longue entre deux temps de décharges distincts.

En variante, dans l'exemple de réalisation particulier illustré sur la figure 12, la sortie du premier comparateur 101 et du deuxième comparateur 112 sont couplées respectivement à une entrée et à une autre entrée d'un bloc logique, en particulier une porte logique 125 qui, dans cet exemple, réalise une fonction OU (« OR» selon la terminologie anglo-saxonne). Pour cette variante, la durée de la phase de décharge est donc ici rendue plus courte que dans l'exemple précédent.

En variante de l'un ou l'autre des exemples de réalisation précédemment décrits, on peut effectuer une réinitialisation des nœuds N₁, N₂ de l'amplificateur de détection 44₀ de manière différente de celle décrite précédemment avec les transistors de réinitialisation Mrz₁, Mrz₂.

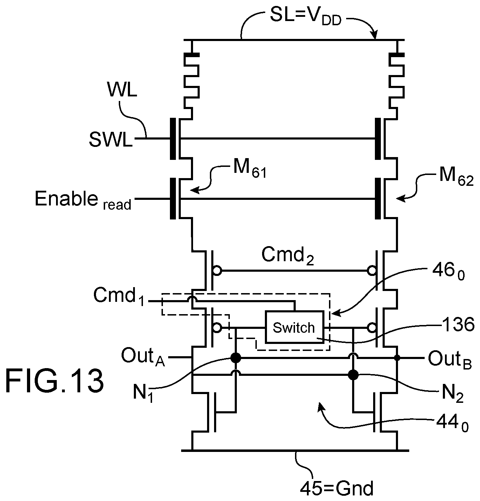

Ainsi, dans l'exemple de réalisation illustré sur la figure 13, on prévoit un étage de réinitialisation 46₀ de l'amplificateur de détection 44₀, cette fois doté d'un élément interrupteur 136 disposé entre les nœuds N₁, N₂ de l'amplificateur de détection 44₀, et dont l'état, ouvert ou fermé, est contrôlé par le biais du signal de commande Cmd₁.

Ainsi, au lieu de réinitialiser l'amplificateur de détection 44₀, en connectant ou couplant ses nœuds N₁, N₂ à une ligne d'alimentation 45 mise à la masse ou à un potentiel d'alimentation Vdd, on peut court-circuiter ces nœuds N₁, N₂ pour effectuer cette réinitialisation.

L'élément interrupteur 136 est ainsi configuré pour, en fonction de l'état du signal de commande Cmd₁, connecter entre eux les nœuds N₁, N₂ de l'amplificateur de détection, puis déconnecter entre eux les nœuds N₁, N₂ de l'amplificateur de détection.

L'élément interrupteur 136 peut être réalisé de plusieurs manières en fonction de la technologie utilisée et du type de transistors formant l'amplificateur de détection. Par exemple l'élément interrupteur 136 peut être réalisé par une porte de transmission CMOS typiquement formée d'un transistor NMOS et d'un PMOS connectés en parallèle. Selon un autre exemple de réalisation, lorsque l'amplificateur de détection 44₀ est comme sur la figure 13, relié à une ligne d'alimentation 45 mise à la masse Gnd, l'élément interrupteur 136 peut être un transistor NMOS dont la grille est commandée par le premier signal de commande Cmd₁.

En variante, lorsque l'amplificateur de détection 44₀ est, comme dans l'exemple de réalisation illustré sur les figures 5A-5B, relié à la tension d'alimentation Vdd, l'élément interrupteur 136 peut être sous forme d'un transistor de type PMOS.

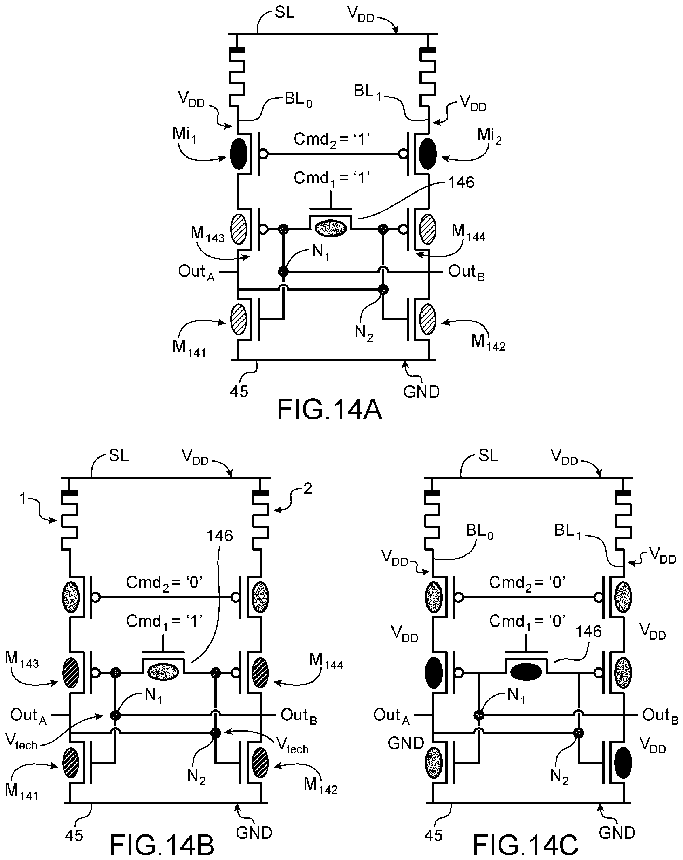

Avec un tel étage de réinitialisation, un fonctionnement en trois phases tel que décrit précédemment peut être conservé. Un tel fonctionnement est représenté sur les figures 14A-14C illustrant un exemple de réalisation particulier avec un élément interrupteur sous forme d'un transistor 146, ici de type NMOS, agencé entre les nœuds N₁ et N₂ et apte, en fonction de l'état du signal de commande Cmd₁ appliqué sur sa grille alternativement à relier entre eux ou connecter les nœuds N₁ et N₂ et déconnecter les nœuds N₁ et N₂ l'un de l'autre.

L'amplificateur de détection 44₀ est dans cet exemple relié à une ligne d'alimentation 45 mise à la masse GND et les transistors d'isolation Mi₁, Mi₂ sont de type PMOS.

Une phase dite « d'attente » est tout d'abord effectuée (figure 14A). Lors de cette phase, une désactivation des transistors d'isolation Mi₁, Mi₂ commandée par le signal Cmd₂, dans cet exemple mis à l'état '1', est effectuée afin d'isoler l'amplificateur de détection 44₀ des lignes de bits BL₀, BL₁. On impose ici aux lignes de bit BL₀, BL₁ un potentiel égal ou sensiblement égal au potentiel VDD auquel se trouve dans cet exemple la ligne de source SL.

Dans le même temps, le premier signal de commande Cmd₁, dans cet exemple mis à l'état '1', permet d'établir le court-circuit et relier ainsi entre eux les nœuds N₁, N₂ de l'amplificateur de détection 44₀. Lors de la phase d'attente ici décrite, on peut noter que dans cet exemple les transistors M₁₄₁, M₁₄₂, M₁₄₃, M₁₄₄ de l'amplificateur de détection 44₀ sont dans un état incertain, ce qui ne gêne pas le fonctionnement de l'opération de lecture à proprement parler et qui se déroule principalement dans les étapes suivantes.

Ensuite (figure 14B), lors d'une phase dite « de décharge partielle », on active (deuxième signal de commande Cmd₂, dans cet exemple mis à l'état '0') les transistors d'isolation Mi₁, Mi₂, ce qui permet la circulation de courant dans les deux branches de l'amplificateur de détection 44₀ et donc au potentiel des nœuds N₁, N₂ d'évoluer et ici en particulier de se charger. Le premier signal de commande Cmd₁, dans cet exemple maintenu à l'état '1', permet de maintenir le court-circuit. On se retrouve alors avec un amplificateur de détection 44₀ alimenté en courant et court-circuité. Le potentiel aux nœuds N₁, N₂ va donc se stabiliser à une tension notée ici *V_{tech}* qui peut être typiquement proche de V_{DD}/2 autrement dit de la moitié de la tension d'alimentation VDD appliquée aux éléments résistifs 1, 2. La valeur de cette tension *V_{tech}* dépend de la technologie utilisée et du dimensionnement relatif des différents transistors. Pour une tension *V_{tech}* proche de V_{DD}/2, les transistors M₁₄₁, M₁₄₂, M₁₄₃, M₁₄₄ de l'amplificateur de détection 44₀ sont tous dans un état intermédiaire.

Enfin (figure 14C), lors de la phase subséquente de comparaison du cycle de lecture, on maintient activés les transistors d'isolation et on désactive le transistor 146 interrupteur ce qui permet de déconnecter entre eux les nœuds de l'amplificateur de détection qui peuvent évoluer alors vers des potentiels respectifs différents. Cela entraine par conséquent le basculement de l'amplificateur de détection 44.

Une autre variante de réalisation moins performante que celle décrite précédemment en liaison avec la figure 6 prévoit cette fois de réaliser l'étage de réinitialisation avec un agencement différent des transistors de réinitialisation Mrz₁, Mrzz. Dans cet exemple, la ligne d'alimentation 45 à laquelle une première borne des inverseurs de l'amplificateur de détection est reliée est mise à un potentiel bas correspondant ici à la masse Gnd,

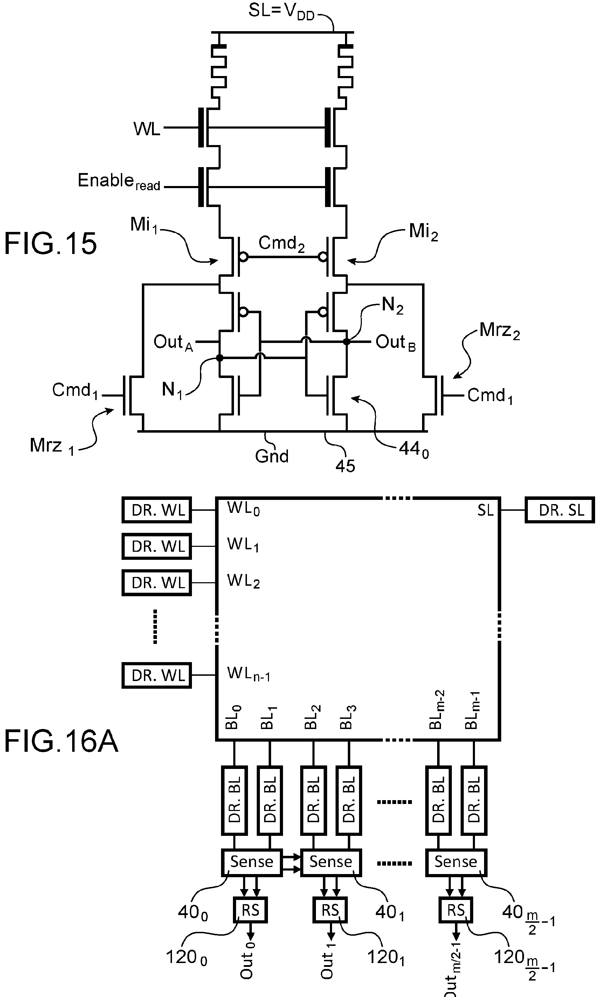

Ainsi, dans l'exemple illustré sur la figure 15, les transistors de réinitialisation Mrz₁, Mrz₂ dont la grille est commandée par le signal Cmd1, ont une électrode relié à la ligne d'alimentation 45, et une autre électrode qui, pour le premier transistor de réinitialisation Mrz₁, est couplée à une deuxième borne d'un inverseur de l'amplificateur de détection et au premier transistor d'isolation Mi₁. Pour le deuxième transistor de réinitialisation Mrz₁, l'autre électrode est couplée à une deuxième borne d'un autre inverseur de l'amplificateur de détection et au deuxième transistor d'isolation Mi₂. Lorsque le signal de cmd1 est actif, à '1', les deux inverseurs se retrouvent entre deux niveaux d'alimentation identiques et par conséquent les nœuds N1 et N2 se déchargent et prennent cette même valeur de tension d'alimentation, correspondant à la masse dans cet exemple.

Après une opération de lecture, les signaux de commande Cmd₁ et Cmd₂ sont typiquement ramenés à leur état initial correspondant à la phase d'attente, c'est-à-dire que le premier signal de commande Cmd₁ est mis dans un état de sorte à activer (i.e. rendre passants) les transistors de réinitialisation tandis que le deuxième signal de commande Cmd₂ est mis dans un état de sorte à désactiver (i.e. rendre bloqués) les transistors d'isolation.

En effectuant cette opération, notamment l'opération de réinitialisation, on est susceptible de perdre l'information lue lors de cette opération de lecture. Pour éviter cela, le circuit de lecture peut être configuré pour attendre que le dispositif mémoire prenne en compte le résultat de lecture, par exemple en n'effectuant la remise en phase d'attente que consécutivement à une capture de l'information lue par une bascule ou un autre bloc de la mémoire, par exemple le bloc d'entrée/sortie de la mémoire ou un bloc de traitement/calcul interne de la mémoire.

Une variante du dispositif mémoire peut être prévue notamment si on l'on souhaite pouvoir anticiper une prochaine lecture et pour cela activer une ligne de mot différente de celle activée pour effectuer une lecture en cours. Un exemple de réalisation est donné sur la figure 16A, avec un élément de mémorisation 120₀ muni d'une bascule RS prévu en sortie de l'amplificateur de détection 44₀ pour permettre de mémoriser l'état de la ou des sorties OutA, OutB de l'amplificateur de détection 44₀, même lorsque les nœuds N₁, N₂ sont réinitialisés. Un tel mode de réalisation s'adapte à une réinitialisation des nœuds N₁, N₂ telle que décrite en liaison avec les figures 4 à 7, par mise à un même potentiel, en particulier à la masse, à l'aide de deux transistors de réinitialisation.

Dans l'exemple illustré sur la figure 16A, les éléments 120_{0,}...,120_{(m/2)-1} de mémorisation sont prévus en pied de colonne et chacun relié aux sorties OutA et OutB des amplificateurs de détection 40₀, ..., 40(_{m/2)-1}. Ainsi, les résultats d'une lecture restent en mémoire dans ces bascules jusqu'à la prochaine lecture, ou plutôt jusqu'à la prochaine réinitialisation des nœuds N1 et N2 réalisée préalablement à toute lecture. De telles bascules RS ont pour avantage de pouvoir être formées à l'aide d'un nombre réduit, par exemple de 8 transistors, ce qui permet de limiter l'augmentation de surface occupée par le circuit de lecture.

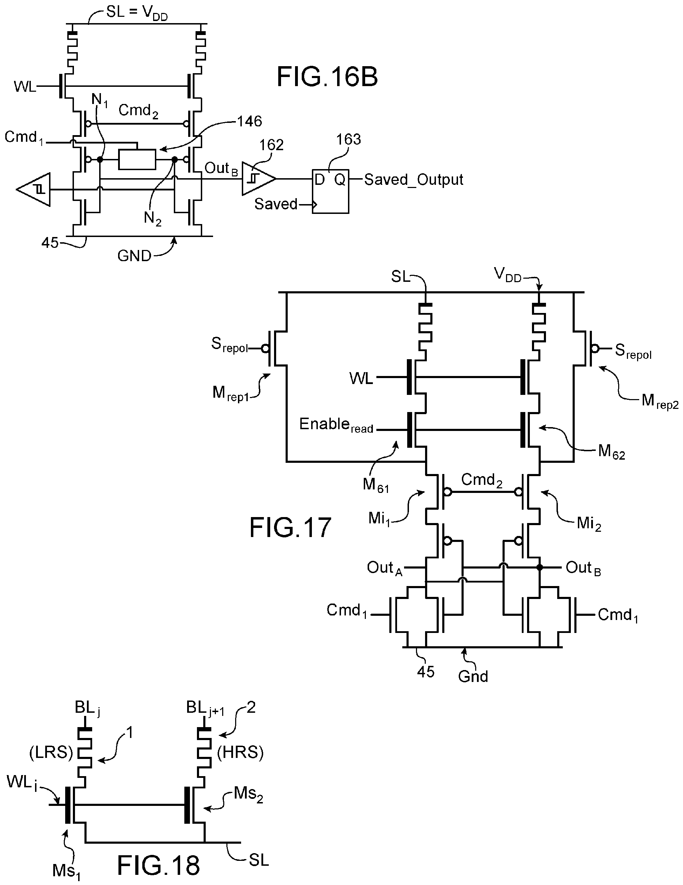

Une variante de réalisation, illustrée sur la figure 16B, peut s'adapter à un dispositif tel que décrit précédemment en lien avec la figure 13, autrement dit lorsque la réinitialisation est effectuée au moyen d'un interrupteur 136 agencé entre les nœuds de lecture N₁, N₂. L'élément de mémorisation 120 prévu en sortie de l'amplificateur de détection 44₀ pour permettre de mémoriser l'état d'une des sorties, ici par exemple de la sortie Out_{B} correspondant au nœud N₁ est cette fois muni d'une bascule 163 de type D. Une telle bascule délivre en sortie un signal Saved_ouput correspondant à une donnée binaire reproduisant celle en sortie OutB du circuit de lecture à chaque front montant d'un signal SAVE de déclenchement de mémorisation.

Typiquement, la bascule D 163 est précédée d'une bascule 162 de Schmitt aussi appelée « trigger de Schmitt » pour permettre de réaliser une mise en forme du signal de sortie et réaliser l'interfaçage avec à une partie logique.

Selon un mode de réalisation particulier, on peut prévoir, en fin d'opération de lecture, d'aider à recharger les lignes de bits BL0 et BL1 et par là même permettre d'enchaîner les lectures plus rapidement, en injectant un courant supplémentaire dans les lignes de bit.

Ainsi, dans l'exemple de réalisation illustré sur la figure 17, le dispositif mémoire est pourvu d'un premier transistor Mrep₁, et d'un deuxième transistor Mrep₂ dits de « repolarisation » et, dotés chacun d'une électrode reliée à une ligne de polarisation, en particulier à la ligne de source SL qui, dans cet exemple, est une ligne d'alimentation haute mise à la tension d'alimentation Vdd, et d'une autre électrode couplée aux lignes de bit, au niveau du premier transistor d'isolation Mi₁ dans le cas du premier transistor de repolarisation Mrep₁ et au niveau du deuxième transistor d'isolation Mi₂ dans le cas du deuxième transistor de repolarisation Mrep₂.

Dans cet exemple de réalisation particulier, ces transistors Mrep₁, Mrep₂ de repolarisation ne sont pas connectés directement aux lignes de bits mais ici aux transistors de séparation M₆₁, M₆₂ ayant typiquement un diélectrique de grille plus épais que celui des transistors du circuit de lecture afin de protéger ce dernier. Une telle configuration permet d'éviter de devoir réaliser des transistors de repolarisation à grille épaisse.

L'activation des transistors Mrep₁, Mrep₂ de repolarisation est réalisée lors de la phase de comparaison, sur la fin de la phase de comparaison, à l'aide d'un signal de commande de repolarisation Sᵣₑₚₒₗ appliqué sur leur grille. On déclenche cette activation un certain temps après le changement d'état du premier signal de commande Cmd₁ des transistors de réinitialisation Mrz₁, Mrz₂ stoppant la réinitialisation. Si l'on prend un exemple de réalisation tel que décrit en lien avec la figure 8 où les lignes de bits BL sont pleinement rechargées en 4 ns, ces transistors de commande repolarisation sont déclenchés en moins de 4 ns après le début de l'opération de lecture, mais après un temps minimum assurant de ne pas interférer avec l'opération d'évaluation se déroulant en phase de comparaison jusqu'au basculement de l'amplificateur.

Un dispositif mémoire suivant l'invention n'est pas nécessairement limité à un agencement des cellules mémoires tel que décrit précédemment en lien avec la figure 1.

Ainsi, afin notamment de limiter la consommation liée à la décharge de la capacité des lignes de bits, on peut mettre en œuvre une variante d'agencement dans lequel la cellule 2T-2R est « retournée » par rapport à l'agencement décrit précédemment. En effet, selon la technologie de mémoire résistive utilisée, il est possible que les électrodes d'une mémoire résistive soient moins capacitives que les sources des transistors de sélection, induisant une capacité totale de ligne de bits plus faible.

Dans l'exemple de réalisation illustré sur la figure 18, des électrodes supérieures des éléments résistifs 1, 2 forment ou sont reliées respectivement à une première ligne de bit BLᵢ et une deuxième ligne de bit BLi₊₁. Pour cette variante, une électrode des transistors de sélection Ms₁, Ms₂, dans l'exemple illustré leur source forme ou est reliée à la ligne de source SL. Avec un tel agencement, on fait ainsi l'économie des capacités de source des transistors de sélection Ms₁, Ms₂ pour ne décharger et recharger que la capacité parasite d'accès aux éléments résistifs physiquement plus petits et généralement moins capacitifs.

Un dispositif mémoire suivant l'invention peut être prévu en outre pour réaliser des opérations logiques, en particulier des opérations en mémoire IMC (pour « In Memory Computing » ou proches de la mémoire NMC (pour « Near Memory Computing »).

Ainsi, on peut notamment effectuer une opération entre une donnée binaire volatile provenant d'un élément externe à la matrice mémoire et au moins une donnée non-volatile stockée dans la mémoire RRAM. Une telle fonctionnalité peut être incorporée au circuit de lecture proposé.

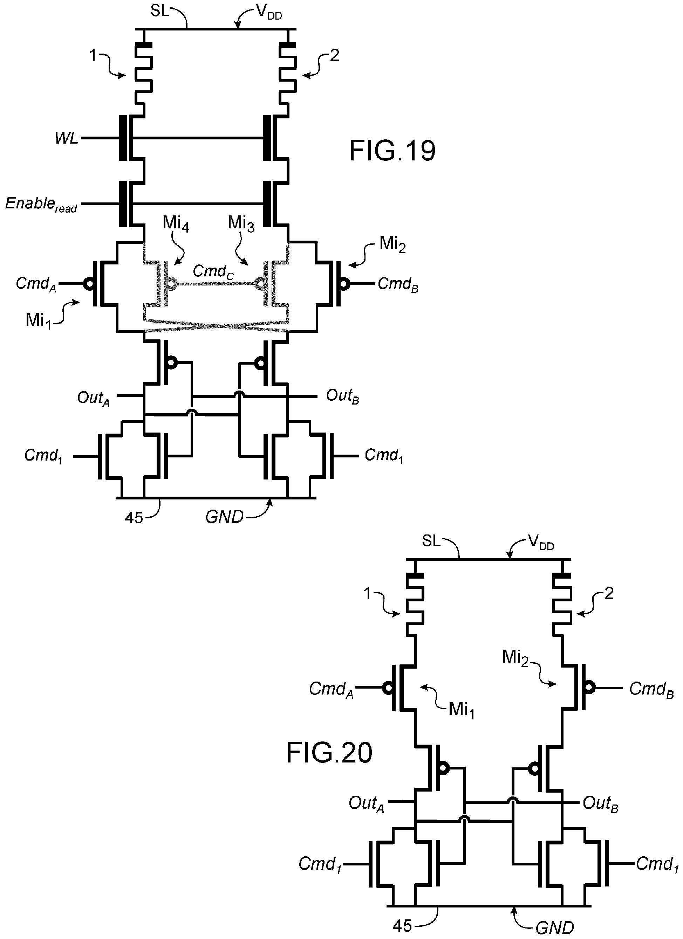

Dans l'exemple de réalisation illustré sur la figure 19, on prévoit pour cela une paire de transistors d'isolation Mi₃, Mi₄ supplémentaire, afin de pouvoir réaliser des opérations logiques : en particulier de type XOR, ou de type AND, ou de type OR entre au moins une donnée « non-volatile » stockée dans la mémoire RRAM et une donnée dite « volatile » provenant d'un élément externe à la matrice mémoire. Un troisième transistor d'isolation Mi₃ et un quatrième transistor d'isolation Mi₄ connectés de façon croisée sont ainsi prévus. Ces transistors d'isolation Mi₃, Mi₄ sont agencés de sorte que le troisième transistor d'isolation Mi₃ a une première électrode couplée au premier transistor d'isolation Mi₁ et une deuxième électrode couplée au deuxième transistor d'isolation Mi₂ et de sorte que le quatrième transistor d'isolation Mi₄ a une première électrode couplée au deuxième transistor d'isolation Mi₂ et une deuxième électrode couplée au premier transistor d'isolation Mi₁. Pour cette variante, le premier transistor d'isolation Mi₁, le deuxième transistor d'isolation Mi₂ sont commandés respectivement pas un signal Cmd_{A} et par un autre signal Cmd_{B}, appelés « signaux de pilotage » appliqués respectivement sur leur grille, tandis que le troisième transistor d'isolation Mi₃ et le quatrième transistor d'isolation Mi₄ sont commandés par un même signal de pilotage Cmd_{C}.

Lorsqu'une simple opération de lecture est effectuée, les signaux Cmd_{A}, Cm_{B} sont identiques et adoptent l'un ou l'autre des séquencements décrits précédemment du signal de commande Cmd₂. Le signal Cmd_{c} appliqué sur la grille des transistors d'isolation Mi₃ et Mi₄ peut être dans ce cas placé constamment dans un état de sorte à bloquer les transistors d'isolation Mi₃ et Mi₄.

Lorsqu'une opération logique est effectuée, les signaux Cmd_{A}, Cmd_{B}, Cmd_{C} peuvent dépendre de la valeur de la donnée logique volatile Data_{VOL} avec laquelle on effectue l'opération. Par exemple, si cette donnée logique volatile Data_{VOL} vaut '1', on active (i.e. met dans un état passant) les transistors d'isolation Mi₁, Mi₂ tout en désactivant (i.e. les mettant dans un état bloqué) les transistors d'isolation Mi₃, Mi₄. Dans ce cas, si l'on traite une donnée logique volatile '0', on active la paire croisée Mi₃, Mi₄, tout en désactivant (i.e. les mettant dans un état bloqué) les transistors d'isolation Mi₁, Mi₂.

Pour appliquer une fonction XOR, les signaux de pilotage Cmd_{A} et Cmd*_{B}* sont prévus comme pour une lecture normale, de sorte à activer les transistors d'isolation Mi₁, Mi₂ tandis que les transistors d'isolation Mi₃, Mi₄ sont désactivés lorsque la donnée Data_{VOL} volatile est *Data_{VOL}* = '0'. Lorsque *Data_{VOL}* = '1', le signal Cmd_{C} est prévu de manière à activer la paire croisée Mi₃, Mi₄, tandis que les transistors d'isolation Mi₁, Mi₂ sont désactivés.

Le dispositif n'est pas limité à l'implémentation d'une fonction XOR ou NXOR et peut permettre également d'implémenter d'autres fonctions logiques, en particulier une fonction OR et/ou une fonction AND ainsi que leur complémentaires.

Pour les opérations de type AND ou OR, en fonction de la valeur de la donnée volatile *Data_{VOL},* le résultat est soit directement égal à la valeur de la donnée non volatile *Data_{NON-VOL},* soit indépendant de la donnée non volatile *Data_{NON_VOL}.*

Dès lors, un pilotage adapté des signaux Cmd*_{A}* et Cmd*_{B}* peut permettre de biaiser la lecture dans les cas où le résultat est indépendant de *Data_{NON_VOL}.*

Avec un dispositif tel qu'illustré sur la figure 19, la réalisation d'opérations logiques de type OR et AND peut être réalisée à l'aide des transistors d'isolation Mi₁, Mi₂, sans utiliser la paire croisée Mi₃, Mi₄. Le signal de pilotage Cmd_{C} est dans ce cas prévu de sorte à désactiver (i.e. rendre bloqués) les transistors d'isolation Mi₃, Mi₄ supplémentaires.

Si l'on souhaite ne réaliser que des opérations de type OR et AND (ou complémentaires), on peut donc en variante prévoir un circuit de lecture comme sur la figure 20, avec les transistors d'isolation Mi₁, Mi₂, sans la paire croisée supplémentaire de transistors d'isolation.

Dans un cas, par exemple, où l'on prévoit la mise en œuvre de fonctions OR et AND, avec un dispositif dans lequel un '1' logique mémorisé dans une cellule élémentaire est codé en forçant le premier élément résistif 1 à LRS et le deuxième élément résistif 2 à HRS : lorsqu'on met en œuvre une fonction logique OR on n'active que le premier transistor d'isolation Mi₁ par le biais du signal Cmd_{A}.

Dans ce cas, pour effectuer une fonction AND on n'active que le deuxième transistor d'isolation Mi₂ par le biais du signal Cmd_{B}.

Ainsi, au niveau de la génération des signaux Cmd_{A}, Cmd_{B}, Cmd_{C}, ces signaux dépendent de si l'opération effectuée est une opération de lecture simple ou bien de l'opération logique choisie, ainsi que de la valeur d'une donnée binaire volatile Data_{VOL} qui sert d'opérande.

Avec un dispositif tel qu'illustré par exemple sur la figure 19, on peut se retrouver avec 4 modes de fonctionnement différents du circuit de lecture :
- un mode lecture « normale »,
- un mode dans lequel une première opération logique est effectuée, en particulier une opération XOR,
- un mode dans lequel une deuxième opération logique est effectuée, en particulier une opération AND,
- et un mode dans lequel une troisième opération logique est effectuée, en particulier une opération OR.

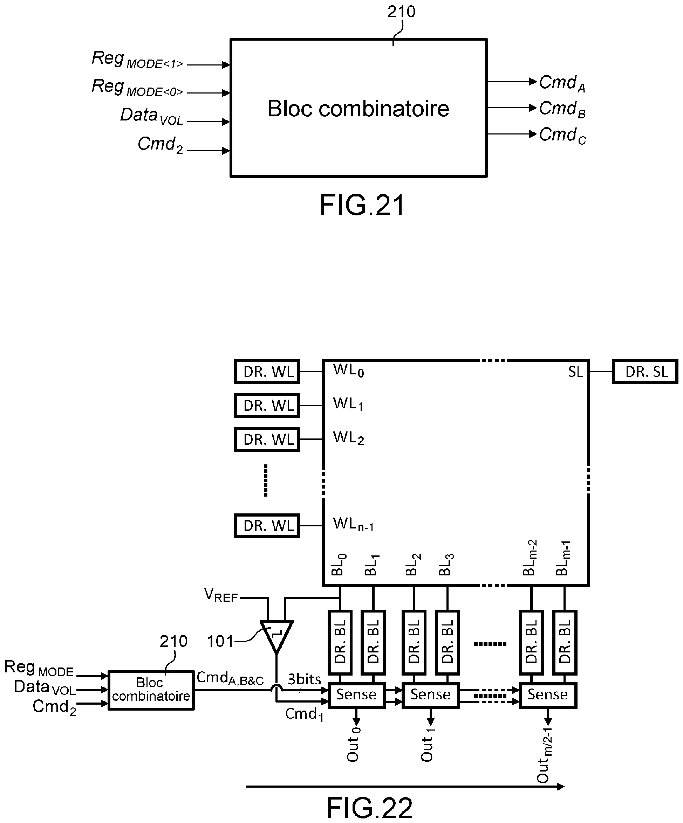

Le circuit de commande qui produit les signaux de pilotage Cmd_{A}, Cmd_{B}, Cmd_{C} peut être doté d'un bloc de commande 210 numérique, comme illustré sur la figure 21, qui peut être formé d'un ensemble de portes logiques et qui, en fonction de ses entrées RegMODE<1>, RegMODE<0>, Data_{VOL}, permet d'effectuer une sélection entre les différents modes de sélection précités.

Pour coder quatre modes de fonctionnement distincts, on peut utiliser deux bits d'entrée : RegMODE<1>, et RegMODE<0> du bloc numérique 210, comme dans le tableau donné ci-dessous.

| **Mode** | **REG_{MODE<1>}** | **REG_{MODE<0>}** |
|---|---|---|
| Lecture simple | 0 | 0 |
| XOR | 0 | 1 |
| AND | 1 | 0 |
| OR | 1 | 1 |

Les signaux de pilotage Cmd_{A}, Cmd_{B}, Cmd_{C} peuvent être produits à partir du signal de commande Cmd₂ dont l'évolution peut être telle que décrite précédemment. Rappelons, que dans le cas d'une lecture simple, on a typiquement les signaux de pilotage Cmd_{A} et Cmd_{B} identiques au signal de commande Cmd₂.

La manière d'encoder une donnée dans une cellule, la sortie de l'amplificateur de détection 44₀ observée lorsqu'on effectue une lecture ou une opération parmi celle avec OutB reliée au premier nœud N₁ et celle avec OutA reliée au deuxième nœud N₂, la manière de sélectionner une opération logique donnée relèvent de choix de l'Homme du Métier et peuvent être distincts de ceux décrits précédemment.

Un bloc de commande 210 permettant de produire les signaux de pilotage Cmd_{A}, Cmd_{B}, Cmd_{C} des transistors d'isolation Mi₁, Mi₂ peut être associé à des moyens tels que décrits précédemment pour permette de produire le signal de commande Cmd₁ des transistors de réinitialisation Mrz₁, Mrz₂.

Ainsi, dans l'exemple de réalisation de la figure 22, le bloc de sélection 210 est intégré à un circuit de commande doté du comparateur 101 produisant en sortie le premier signal de commande Cmd₁.

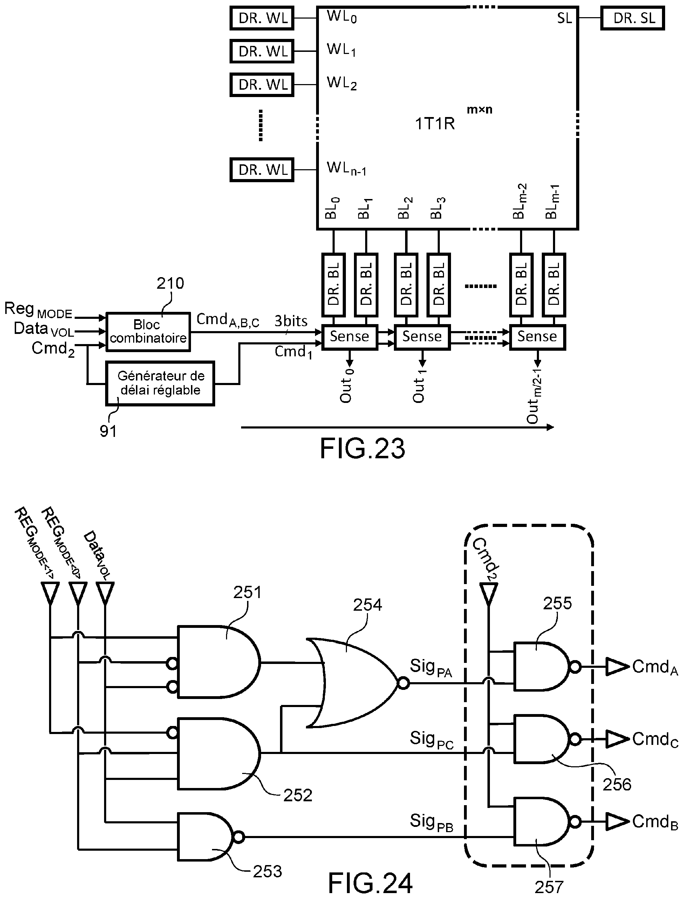

Dans la variante de réalisation de la figure 23, le bloc de sélection 210 est cette fois associé au générateur de délai réglable 91 qui produit le premier signal de commande Cmd₁ à partir du deuxième signal de commande Cmd₂.

Un exemple de table de vérité du bloc de sélection 210 est donné ci-dessous, avec différents états de signaux Cmd_{A}, Cmd_{B}, Cmd_{C} pour permettre de piloter respectivement la grille du premier transistor d'isolation Mi₁, la grille du deuxième transistor d'isolation Mi₂, et les grilles respectives de la paire supplémentaire de transistors d'isolation Mi₃, Mi₄.

| **Mode** | **REG_{MODE<1>}** | **REG_{MODE<0>}** | **Data_{VOL}** | **Cmd_{A}** | **Cmd_{C}** | **Cmd_{B}** | **Type de lecture** |
|---|---|---|---|---|---|---|---|
| Lecture simple | 0 | 0 | 0 | '1' | '0' | '1' | Normal |
| | | | 1 | '1' | '0' | '1' | Normal |
| XOR | 0 | 1 | 0 | '1' | '0' | '1' | Normal |
| | | | 1 | '0' | '1' | '0' | inversé |
| AND | 1 | 0 | 0 | '0' | '0' | '1' | Force '0' |
| | | | 1 | '1' | '0' | '1' | Normal |
| OR | 1 | 1 | 0 | '1' | '0' | '1' | Normal |
| | | | 1 | '1' | '0' | '0' | Force '1' |

Un bloc de sélection 210 répondant à une telle table de vérité peut être implémenté par exemple à l'aide d'un agencement de portes logiques 251, 252, 253, 254, 255, 256, 257, tel que donné à titre d'exemple sur la figure 24.

Un dispositif mémoire tel que décrit précédemment peut trouver des applications notamment dans la mise en œuvre de systèmes à réseaux de neurones pour lesquels on cherche à limiter autant que possible la consommation et dans lesquels les accès mémoires en lecture sont nombreux et incessants.

Dans de tels systèmes, les cellules mémoires RRAM peuvent permettre de stocker un poids synaptique. Dans ce cas, la mémoire peut être lue en effectuant un accès en lecture sur une rangée complète de cellules, en particulier sur une ligne (rangée horizontale) de cellules.

En variante de l'un ou l'autre des exemples de réalisation décrits précédemment, on peut, en remplacement des cellules de type 2T-2R, prévoir une matrice avec des cellules de type dit « 1T-1R » dans laquelle la valeur mémorisée est conservée cette fois à l'aide d'un seul élément résistif de résistivité variable entre deux niveaux de résistivité LRS et HRS, cet élément résistif ayant une électrode couplée à un transistor de sélection.

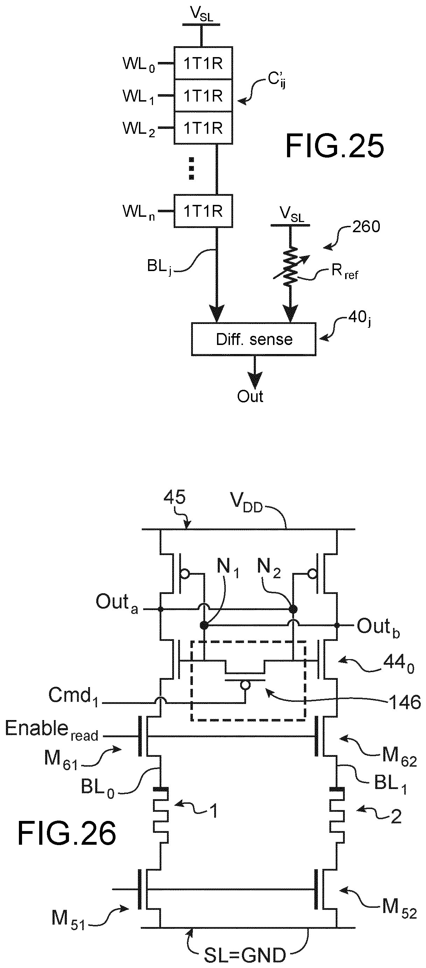

Dans de telles cellules élémentaires, le transistor de sélection est également commandé par un signal SWL véhiculé par une ligne de mot WLᵢ permettent ainsi, alternativement de coupler ou de découpler l'élément résistif à une ligne de bit BLj. La ligne de bit BLj+1 est, comme cela est illustré dans l'exemple de réalisation de la figure 25, typiquement commune aux cellules C'ᵢⱼ d'une même rangée verticale ou colonne de cellules et la matrice ne compte, dans cet exemple de réalisation particulier, qu'une seule ligne de bit par rangée verticale ou colonne.

En périphérie de la matrice, et en particulier en pied de chaque colonne, on prévoit alors un circuit de lecture 40ⱼ pour permettre de traduire en une donnée binaire l'état résistif de l'élément résistif d'une cellule mémoire. Le circuit de lecture 40ⱼ d'une colonne de cellules peut avoir une structure telle que décrite précédemment mais est ici associé à une seule ligne de bit BLᵢ et à une ligne de référence 260 dotée d'une résistance R_{ref} afin de pouvoir déterminer une différence de courant entre le courant circulant sur la ligne de bit et un courant de référence circulant sur la ligne de référence 260 et d'évaluer ainsi si l'élément résistif mémorise une valeur correspondant à un état HRS ou bien une autre valeur correspondant à un état LRS.

On notera que la ligne de référence est dans cet exemple construite et polarisée de façon similaire à une cellule mémoire 1T1R lorsque la cellule mémoire est sélectionnée pour lecture. Ainsi, la résistance de référence Rref est dans cet exemple connectée à une ligne d'alimentation identique en partageant par exemple la même ligne de source. On peut par exemple prévoir une résistance de référence Rref par colonne, positionnée à l'opposé ou à proximité de l'amplificateur 40j (donc tout en haut ou tout en bas de la matrice) et reliée à l'amplificateur 40j par une ligne de bit de référence.

Les opérations de lecture réalisées avec cette ligne de référence sont une lecture différentielle pouvant être réalisée de façon similaire aux exemples d'opérations décrits précédemment. La seule différence réside dans le fait que la résistance de référence Rref va présenter une valeur de résistivité qui ne sera pas la valeur HRS ou LRS correspondant à celle pouvant être prise par une cellule mémoire, mais une valeur intermédiaire entre ces deux valeurs. Ainsi, ce mode de réalisation avec des cellules mémoire « single » de type 1T1R peut en pratique être utilisé quand l'écart entre les valeurs HRS et LRS est suffisant.

Autrement dit, il faut s'assurer que la plage de variation de valeurs possibles de résistances HRS et celle de valeurs possibles de résistance LRS (dûe aux dispersions technologiques, à la température) sont non seulement non recouvrantes, mais suffisamment espacées pour pouvoir envisager d'utiliser une résistance de référence dont la plage de variation de valeurs devra se loger entre les deux autres plages HRS et LRS. Si l'on se réfère à un agencement avec des transistors d'isolation tel que décrit précédemment, on peut ainsi prévoir de coupler la première ligne de bit BLᵢ₋₁ au premier transistor d'isolation Mi₁ tandis que la ligne de référence 260 est couplée au deuxième transistor d'isolation Mi₂. De même, l'homme de l'art saura adapter l'ensemble des modes de réalisation d'un circuit de lecture présentés avec des cellules mémoire 2T2R à l'utilisation d'une unique ligne de bits reliée à une cellule de mémoire 1T1R sélectionnée et d'une ligne de référence 260 avec la résistance Rref.

Avantageusement, si les cellules mémoires 1T1R peuvent être programmés avec plus de deux valeurs de résistance, par exemple, 3, 4, voire plus, alors cet exemple de réalisation avec une ligne de référence et une lecture différentielle permet avantageusement de lire des cellules mémoires multivaluées. A cette fin, la résistance de référence R_{ref}, peut être une résistance variable. On peut alors déterminer la valeur mémorisée par le biais de lectures successives. La valeur de la résistance Rref peut être ainsi modifiée d'une opération de lecture à l'autre afin de pouvoir déterminer plusieurs différences de courant entre le courant circulant sur la ligne de bit et un courant de référence circulant sur la ligne de référence 260 et trouver par essais successifs quelle est la valeur mémorisée dans la cellule résistive.

Selon une variante de réalisation de la ligne de référence, celle-ci comprend une source de courant réalisée autrement qu'avec une résistance de référence reliée à la ligne de source SL. Ainsi, il est possible d'utiliser par exemple un miroir de courant dont la valeur peut être aisément changée selon des techniques de réalisation connues.

Dans l'un ou l'autre des exemples qui ont été décrits précédemment, on prévoit un étage d'isolation, en particulier muni de deux transistors d'isolation Mi₁, Mi₂ pour alternativement coupler et découpler la ou les lignes de bits à l'amplificateur de détection 44₀ afin, lors d'une phase d'attente entre deux lectures, de pouvoir limiter la consommation statique, et en outre de pouvoir anticiper l'opération de réinitialisation si besoin.

Une variante de réalisation sans transistor d'isolation est cette fois illustrée sur la figure 26 où l'amplificateur de détection 44₀ est connecté aux transistors de séparation M₆₁, M₆₂. Ces transistors de séparation M₆₁, M₆₂ sont constamment passants lors d'opérations de lecture successives, par le biais d'un signal Enable_{read} maintenu actif entre deux lectures et constamment non passant lors d'opérations d'écriture. Ainsi, lors d'opérations d'écriture le signal Enable_{read} se trouve dans un état différent de celui dans lequel il se trouve lors des opérations de lecture. Dans cet exemple, l'étage de réinitialisation 46₀ est formé d'un transistor 146 interrupteur, agencé entre le premier nœud N₁ et le deuxième nœud N₂ de lecture de l'amplificateur de détection 44₀.

Dans cet exemple de réalisation, l'amplificateur de détection 44₀ est relié à une ligne d'alimentation 45 haute i.e. mise à VDD, tandis que les cellules sont reliées à la ligne de source SL cette fois formant une ligne d'alimentation basse i.e. mise à la masse GND.

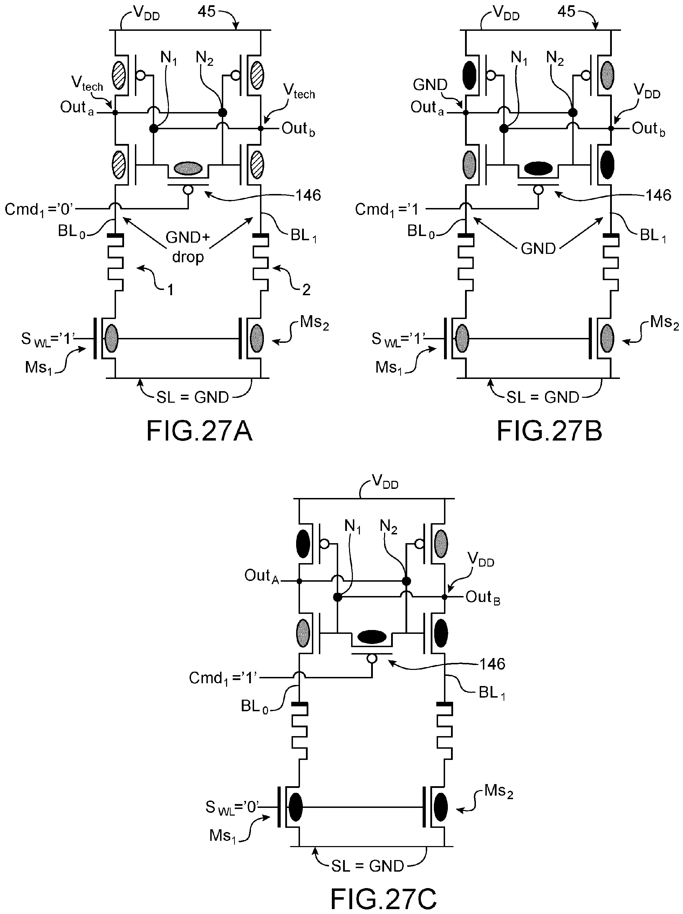

Une opération de lecture en plusieurs phases et suivant cette variante d'agencement est illustrée sur les figures 27A- et 27B. Par souci de simplification, les transistors de séparation ne sont pas représentés sur ces figures dans la mesure où ils restent constamment activés tant que l'on réalise des accès en lecture sur la matrice.

Les signaux de commande des différentes phases de fonctionnement sont cette fois le signal de commande Cmd₁ appliqué sur la grille du transistor interrupteur 146 et le signal SWL issu de la ligne de mot WL et appliqué sur la grille du ou des transistors de sélection Ms₁, Ms₂.

Selon une phase dite de « décharge partielle » (illustrée sur la figure 27A), on active les transistors de sélection Ms₁, Ms₂, par exemple par le biais d'un signal SWL dans un état '1' lorsqu'ils sont de type NMOS, tandis que le transistor interrupteur 146 est également activé par le biais du signal Cmd₁ = '0' lorsque ce transistor est de type PMOS.

Les lignes de bits BL₀, BL₁ sont couplées, par l'intermédiaire des éléments résistifs, à la ligne de source SL ici mise à la masse. Durant cette phase de décharge partielle, les lignes de bits BL₀, BL₁ voient leurs potentiels augmenter légèrement progressivement, mais les nœuds de lecture N₁ et N₂ sont maintenus connectés l'un à l'autre. Une réinitialisation est alors effectuée pour ne pas faire commuter l'amplificateur de détection 44₀ du fait des courants de décharge partielle des lignes de bit, comme précédemment expliqué.

Selon une phase dite « de comparaison » (illustrée sur la figure 27B), on maintient les transistors de sélection Ms₁, Ms₂, activés, SWL étant maintenu dans le même état (dans cet exemple SWL = '1'), le transistor interrupteur 146 est cette fois rendu bloqué (Cmd₁ = '1') de sorte à déconnecter les nœuds N₁, N₂ l'un de l'autre pour permettre à leurs potentiels respectifs d'évoluer indépendamment l'un de l'autre. L'amplificateur de détection 44₀ est alors amené à basculer et l'on peut obtenir le résultat de lecture, une fois cette bascule de l'amplificateur réalisée.

Lorsque l'amplificateur de détection 44₀ a basculé et qu'il se trouve dans un état verrouillé, celui-ci présente un état de forte impédance aux lignes de bits BL₀, BL₁ qui sont dès lors ramenés à la masse par l'intermédiaire de courants transitoires à travers la cellule mémoire, des courants faibles dans la mesure où les lignes de bit ne se sont pas beaucoup éloignées du potentiel de masse lors de l'étape de décharge partielle. Une fois que le potentiel des lignes de bits correspond à celui de la masse, il n'y a quasiment plus de courant qui circule ni dans la cellule mémoire, ni dans l'amplificateur. On peut ainsi souhaiter maintenir cet état de consommation quasi-nulle jusqu'à une prochaine opération de lecture. Cet état correspond à un état d'attente entre deux lectures successives.

On met ainsi ensuite le dispositif dans une phase dite de « transition » (figure 27C). Cette phase de transition est implémentée lorsqu'on veut lire des cellules de rangées horizontales différentes et activer ainsi successivement deux lignes de mots WL différentes.

Lors de cette phase de transition, la ligne de mot WL est désactivée (signal de commande SWL = '0') et permet de découpler la cellule et par conséquent les lignes de bits de la ligne de source SL, tandis que le transistor interrupteur 146 reste désactivé (i.e. bloqué avec Cmd₁ = '1'). Lors de cette phase de « transition », l'amplificateur 44₀ n'est plus alimenté et n'entraine pas de consommation en courant. Les nœuds de l'amplificateur reliés aux lignes de bits BL₀, BL₁ se retrouvent alors flottants mais sans circulation de courant possible leurs potentiels respectifs sont maintenus.

Lorsqu'on effectue une autre opération de lecture sur une nouvelle cellule d'une autre ligne, une autre ligne de mot est alors activée (signal de commande SWL = '1') et cela permet de coupler la nouvelle cellule et par conséquent les lignes de bits à la ligne de source SL permettant de retrouver un état d'attente similaire à celui représenté en figure 27A. Cette phase de transition est en fait la continuité de la phase d'attente dans la mesure où l'amplificateur de lecture 440 est inactif (pas d'opération de réinitialisation, ni de comparaison).

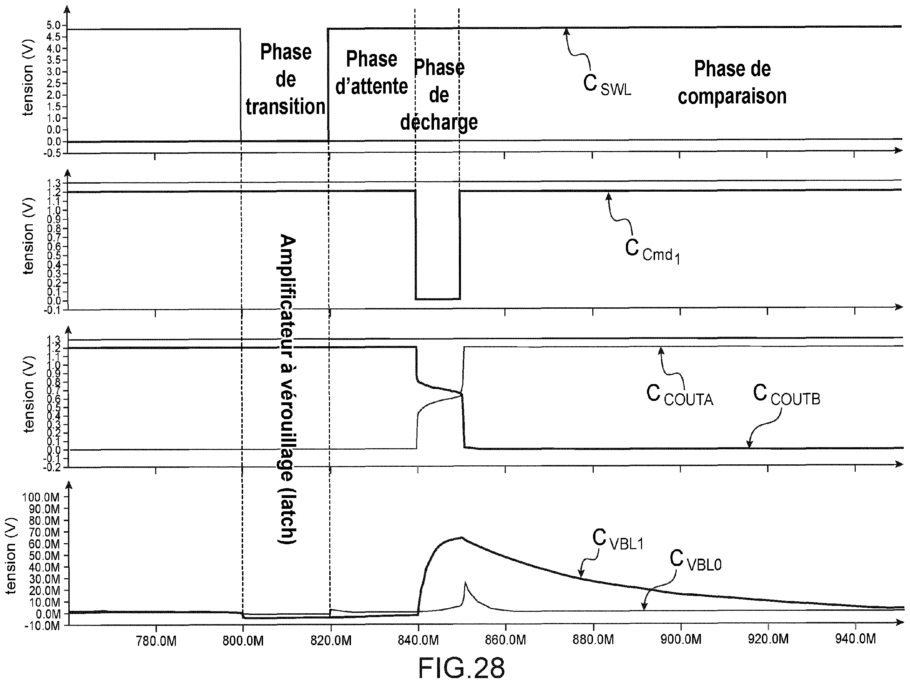

Les différentes phases d'attente (avec ou sans phase de transition), de décharge partielle, de comparaison, susceptibles d'être mises en œuvre avec un circuit de lecture tel que décrit précédemment en lien avec la figure 26, sont représentées sur la figure 28.

Sur cette figure la courbe d'évolution CSWL donne l'évolution du signal SWL appliqué sur la ligne de mot et permettant alternativement de désactiver les transistors de sélection lors de la phase de transition puis d'activer les transistors de sélection lors des phases d'attente, de décharge et de comparaison. On notera que par soucis de simplification, dans cette figure et celle présentée précédemment, un seul signal CSWL est représenté pour potentiellement plusieurs lignes de mot activées successivement.

La courbe C_{cmd1}, est représentative du signal de commande Cmd₁ de l'interrupteur de réinitialisation, permettant alternativement de découpler l'un de l'autre les nœuds de lecture N₁, N₂ lors de la phase de transition puis d'attente, puis de coupler les nœuds de lecture N₁, N₂ lors de la phase de décharge partielle et de les découpler à nouveau lors de la phase de comparaison. Les courbes Cv_{BL0}, Cv_{BL1} servent à illustrer respectivement une tension sur la première ligne de bit BL₀, une tension sur la deuxième ligne de bit BL₁, tandis que les courbes CoutA, CoutB donnent l'évolution des potentiels respectifs des nœuds N₂, N₁.

On constate que la phase de comparaison est constituée d'une phase de basculement très courte pendant laquelle les sorties de l'amplificateur basculent d'un côté ou de l'autre en fonction des différences de résistivité, puis d'une phase plus longue de recharge des lignes de bit. Cette phase de recharge s'apparente en fait à une phase d'attente avant une nouvelle opération de décharge partielle. Ainsi, on appelle de façon générale « phase d'attente » toute phase pendant laquelle les lignes de bit ne véhiculent plus de courant significatif entre les cellules mémoire et l'amplificateur 44₀, contrairement à ce qui se passe pendant une phase de décharge partielle et le début de la phase de comparaison jusqu'au basculement de l'amplificateur. Une telle phase d'attente peut inclure une phase dite de transition dans le cas où la lecture suivante est réalisée sur une autre ligne. Dans le cas où des transistors d'isolation sont prévus, il est possible lors d'une phase d'attente de réaliser une opération de réinitialisation de l'amplificateur 440. Le choix de réaliser ou non une opération de réinitialisation pendant une phase d'attente est entre autre fonction du type de circuit de réinitialisation choisi, de la présence ou non d'un élément de type bascule (D ou RS ou autre).

Les courbes de la figure 28 ont été obtenues avec des exemples de circuits tels que représentés en figures 27 pour lesquels aucun transistor d'isolation n'est utilisé. On voit qu'il est tout à fait possible de réinitialiser l'amplificateur lors de la phase de décharge partielle, sans avoir besoin d'une phase d'attente préalable avec réinitialisation. En outre, les transistors d'isolation ne sont pas indispensables pour assurer qu'aucun courant statique inutile ne circule lors des phases d'attente.

Il est possible d'enchaîner des opérations de lecture à proprement parler comprenant une phase de décharge partielle avec réinitialisation, puis une phase de comparaison présentant une durée minimum assurant le basculement de l'amplificateur quelles que soient les dispersions des valeurs de résistivité des cellules mémoire. La phase de recharge des lignes de bit en fin de phase de comparaison peut être relativement courte et il n'est pas indispensable d'atteindre la recharge complète des lignes de bit avant de déclencher une nouvelle phase de pre-décharge pour une nouvelle lecture. Une utilisation de transistors de repolarisation permettant de réaliser une polarisation active des lignes de bits BL₀, BL₁ a été décrite précédemment en liaison avec la figure 17. On peut également prévoir de tels transistors avec un dispositif tel que décrit précédemment en lien avec la figure 26.

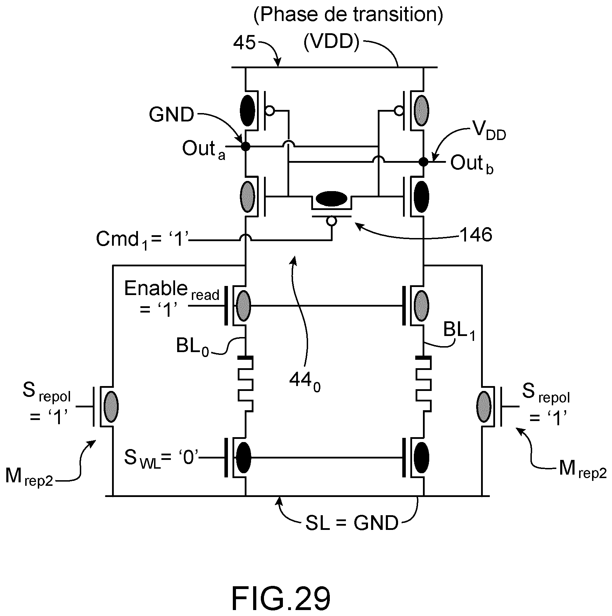

Ainsi, sur la figure 29, le dispositif mémoire est pourvu d'un premier transistor M'rep₁, et d'un deuxième transistor M'rep₂ de « repolarisation » et, dotés chacun d'une électrode reliée à une ligne d'alimentation, en particulier à la ligne de source SL qui, dans cet exemple, est une ligne d'alimentation basse mise à la masse GND, et d'une autre électrode couplée à l'amplificateur de détection 44₀.

Dans cet exemple de réalisation particulier, l'activation des transistors M'rep₁, M'rep₂ de repolarisation est réalisée lors de la phase de transition à l'aide d'un signal de commande de repolarisation Sᵣₑₚₒₗ appliqué sur leur grille pour coupler les lignes de bits à la ligne de source et les placer ainsi à la masse GND. Les transistors M'rep₁, M'rep₂ de repolarisation pourraient également être activés dans un deuxième temps de la phase de comparaison, après un premier temps réservé à la réalisation du basculement de l'amplificateur. Ainsi, par exemple, il est possible de prévoir un système de détection de fin de basculement permettant d'activer les transistors de repolarisation pour accélérer la recharge des lignes de bit vers le niveau de tension de la ligne de source, afin par exemple de pouvoir enchainer plus rapidement un nouveau cycle de lecture avec une nouvelle phase de décharge partielle et de comparaison.

De même, les transistors de repolarisation sont activés lors d'une phase de transition et permettent de maintenir une alimentation de l'amplificateur à verrouillage pendant une phase de transition telle que décrite précédemment. En alimentant l'amplificateur à verrouillage on s'assure ici de maintenir les lignes de bits au potentiel de la ligne de source SL, ici à la masse. En outre, pendant cette phase de transition, on peut réaliser tout ou partie de la phase de recharge des lignes de bit grâce aux transistors de repolarisation. Cela offre également la possibilité de mettre œuvre une phase d'attente qui ne nécessite pas l'activation d'une ligne de mot WL.

Selon une variante non représentée, il est également possible de prévoir un jeu de transistors supplémentaires pour réaliser la phase de décharge partielle des lignes de bit autrement qu'à travers les transistors de séparation et les branches de l'amplificateur, en prévoyant de tels transistors supplémentaires reliant les lignes de bit à la ligne de source SL.

Ainsi de façon générale, la phase de décharge partielle consiste à décharger en partie les lignes de bit en reliant ces dernières à la ligne de source. De façon avantageuse, on utilise pour cela, les transistors déjà existants pour d'autres fonctions, tels que les transistors des branches de l'amplificateur, ou les transistors utilisés pour la phase de réinitialisation. Cependant, il est possible d'utiliser d'autres transistors que ceux-ci.

Un dispositif mémoire ReRAM tel que décrit précédemment peut également être intégré dans des systèmes embarqués de type internet des objets (loT pour « Internet of Things ») ou de type système cyber-physique (CPS, de l'anglais « Cyber-Physical System »).

## Revendications

1. Dispositif de mémoire résistive à accès aléatoire (ReRAM) comprenant :
- une matrice (M₁) de cellules mémoires (Cᵢⱼ) chacune reliée à une première ligne d'alimentation (SL) mise à un premier potentiel d'alimentation, chaque cellule de ladite matrice étant dotée d'au moins un premier élément résistif (1, 2) de résistivité variable et en série avec au moins un premier transistor de sélection (Ms₁, Ms₂),
- un circuit de lecture (40₀) associé à une colonne de cellules de la matrice, le circuit de lecture comprenant :
- un amplificateur de détection (44₀) de type à verrouillage formé d'inverseurs connectés de façon croisée et muni d'un premier nœud de lecture (N₁) et d'un deuxième nœud de lecture (N₂), lesdits inverseurs formant respectivement une première branche et une deuxième branche reliées chacune d'un côté à une deuxième ligne d'alimentation (45) mise à un deuxième potentiel d'alimentation, distinct dudit premier potentiel d'alimentation,
- au moins un premier transistor (Mi₁, M₆₁) de couplage reliant un autre côté de ladite première branche à une première ligne de bits (BL₀) couplée aux premiers éléments résistifs respectifs des cellules de ladite colonne,
- au moins un deuxième transistor (Mi₂, M₆₂) de couplage reliant un autre côté de ladite deuxième branche soit à une deuxième ligne de bits (BL₁) couplée à des deuxièmes éléments résistifs des cellules de ladite colonne, soit à une ligne de référence délivrant un courant de référence ;
- un circuit de commande des opérations de lecture sur la matrice par le biais de signaux (Cmd₂, SWL, Cmd₁) de commande d'éléments interrupteurs, ledit circuit de commande étant configuré pour, lors d'une opération de lecture effectuée sur une cellule donnée de ladite colonne :
- selon une phase d'attente, charger ladite première ligne de bit (BL₀) à un potentiel égal ou proche ou sensiblement égal audit premier potentiel d'alimentation (GND, VDD), puis,
- selon une phase de réinitialisation dudit amplificateur de détection (44₀), par le biais d'au moins un transistor (146, Mrz₁, Mrz₂) de réinitialisation relier le premier nœud de lecture (N₁) et le deuxième nœud de lecture (N₂), de sorte à égaliser les potentiels du premier nœud de lecture (N₁) et du deuxième nœud de lecture (N₂) ;
- selon une phase de décharge partielle, relier la première ligne de bits (BL₀) à la deuxième ligne d'alimentation (45) et lorsque le dispositif comporte la deuxième ligne de bits (BL₁) relier la deuxième ligne de bits à la deuxième ligne d'alimentation (45), de sorte à décharger partiellement ladite première ligne de bit ou lesdites lignes de bits et obtenir aux bornes des cellules de ladite colonne une différence de potentiels non nulle tout en étant inférieure, et en particulier bien inférieure, à une différence de potentiels entre le premier potentiel d'alimentation et ledit deuxième potentiel d'alimentation, la phase de réinitialisation étant déclenchée pendant la phase de décharge partielle ; puis
- selon une phase de comparaison, lors de laquelle lesdits premier et deuxième transistors de couplage (Mi₁, Mi₂, M₆₁, M₆₂) sont rendus passants, et ledit au moins un transistor (146, Mrz₁, Mrz₂) de réinitialisation est rendu non passant, pour permettre une circulation d'un premier courant à travers ladite première branche dudit amplificateur de détection (44₀), la première ligne de bit (BL₀) et un premier élément résistif de ladite cellule et une circulation d'un deuxième courant à travers ladite deuxième branche dudit amplificateur de détection (44₀) ainsi que soit la ligne de référence soit la deuxième ligne de bit (BL₁) et un deuxième élément résistif de ladite cellule, jusqu'à un basculement dudit amplificateur de détection en fonction d'une différence entre lesdits premier et deuxième courants.

2. Dispositif de mémoire résistive à accès aléatoire selon la revendication 1, dans lequel parmi lesdits éléments interrupteurs figure au moins un premier transistor de réinitialisation (146, Mrz₁, Mrz₂) appartenant à un étage de réinitialisation (46₀) dudit amplificateur de détection (44₀), et commandé par le biais d'un premier signal de commande (Cmd₁), ledit circuit de commande étant configuré pour :
lors de ladite phase de réinitialisation, maintenir passant le premier transistor de réinitialisation (146, Mrz₁, Mrz₂), de sorte à relier entre eux le premier nœud de lecture (N₁) et le deuxième nœud de lecture (N₂), ou relier le premier nœud de lecture (N₁) à la deuxième ligne d'alimentation (45) ou relier une première borne et une deuxième borne du premier inverseur à la deuxième ligne d'alimentation (45), et
lors de la phase de comparaison mettre le premier signal de commande (Cmd₁) dans un deuxième état, distinct dudit premier état, de sorte que ledit premier transistor de réinitialisation (146, Mrz₁, Mrz₂) est non-passant.

3. Dispositif de mémoire résistive à accès aléatoire selon la revendication 2, dans lequel ledit au moins un premier transistor de couplage est ou comprend un premier transistor d'isolation (Mi₁) agencé entre ledit amplificateur de détection (44₀) et ladite première ligne de bit (BL₀), ledit premier transistor d'isolation (Mi₁) étant commandé par le biais d'au moins un deuxième signal de commande (Cmd₂, Cmd_{A}, Cmd_{B}), le circuit de commande étant configuré en outre pour :
lors de la phase d'attente, mettre ledit deuxième signal de commande (Cmd₂) dans un état donné de sorte à rendre bloqué le premier transistor d'isolation (Mi₁) et isoler ainsi la première ligne de bit (BL₀) dudit amplificateur de détection (44₀) et mettre ledit premier signal de commande (Cmd₁) dans un état de sorte à maintenir passant le premier transistor de réinitialisation (146, Mrz₁, Mrz₂), ledit circuit de commande étant configuré en outre pour lors desdites phases de décharge partielle et de comparaison : mettre ledit deuxième signal de commande (Cmd₂) dans un autre état, distinct dudit état donné, de sorte à rendre passant le premier transistor d'isolation (Mi₁) et connecter ainsi la première ligne de bit (BL₀) audit amplificateur de détection (44₀),

4. Dispositif selon la revendication 3, dans lequel les cellules mémoires (Cᵢⱼ) sont dotées chacune d'au moins un deuxième élément résistif (2) en série avec un deuxième transistor de sélection (Ms₂), ladite colonne de cellules étant couplée à ladite deuxième ligne de bits (BL₁,..., BLₘ₋₁), ledit au moins un deuxième transistor de couplage étant ou comprenant un deuxième transistor d'isolation (Mi₂) entre l'amplificateur de détection (44₀) et ladite deuxième ligne de bit, le deuxième transistor d'isolation (Mi₁, Mi₂) étant commandé par le biais dudit deuxième signal de commande (Cmd₂, Cmd_{A}, Cmd_{B}).

5. Dispositif de mémoire résistive à accès aléatoire selon la revendication 4, dans lequel le circuit de lecture (40₀) comprend en outre : un troisième transistor d'isolation (Mi₃) et un quatrième transistor d'isolation (Mi₄), le troisième transistor d'isolation (Mi₃) et le quatrième transistor d'isolation (Mi₄) étant connectés de façon croisée de sorte que le troisième transistor d'isolation (Mi₃) a une première électrode couplée au premier transistor d'isolation (Mi₁) et une deuxième électrode couplée au deuxième transistor d'isolation (Mi₂) et de sorte que le quatrième transistor d'isolation (Mi₄) a une première électrode couplée au deuxième transistor d'isolation (Mi₂) et une deuxième électrode couplée au premier transistor d'isolation (Mi₁).

6. Dispositif de mémoire résistive à accès aléatoire selon l'une des revendications 4 ou 5, apte à effectuer des opérations en mémoire, en particulier au moins une opération logique, ledit circuit de commande étant doté en outre : d'un bloc logique (210) de commande configuré pour produire des signaux de pilotage (Cmd_{A}, Cmd_{B}) des grilles respectives desdits transistors d'isolation (Mi₁, Mi₂) en fonction d'au moins un signal numérique de sélection de mode de fonctionnement émis sur une ou plusieurs entrées (RegMODE<1>, RegMODE<0>) dudit bloc logique de commande et d'une donnée logique volatile (Data_{VOL}) en entrée dudit bloc logique (210) de commande, pour sélectionner entre un premier mode de fonctionnement du circuit de lecture correspondant à une opération de lecture et au moins un autre mode de fonctionnement du circuit de lecture correspondant à la mise en œuvre d'au moins une opération logique entre au moins une donnée non-volatile mémorisée dans ladite cellule donnée de ladite rangée donnée de cellules et la donnée logique volatile (Data_{VOL}) en entrée dudit bloc logique (210) de commande, ledit bloc logique (210) de commande étant configuré pour :
- lorsque le signal numérique de sélection a une première valeur correspondant à une sélection d'une opération de lecture : appliquer des signaux de pilotage (Cmd_{A}, Cmd_{B}) de la grille du premier transistor d'isolation (Mi₁) et à la grille du deuxième transistor d'isolation (Mi₂) correspondants au deuxième signal de commande (Cmd₂),
- lorsque le signal numérique de sélection a une autre valeur distincte de la première valeur et correspondant à une sélection d'une opération logique : transmettre un premier signal de pilotage (Cmd_{A}) à la grille du premier transistor d'isolation (Mi₁) et un deuxième signal de pilotage (Cmd_{B}) à la grille du deuxième transistor d'isolation (Mi₂), de sorte à bloquer l'un desdits premier et deuxième transistors d'isolation (Mi₁, Mi₂) tout en rendant passant l'autre desdits premier et deuxième transistors d'isolation (Mi₁, Mi₂).

7. Dispositif de mémoire résistive à accès aléatoire selon la revendication 6, dans lequel le circuit de lecture (40₀) comprend en outre : un troisième transistor d'isolation (Mi₃) et un quatrième transistor d'isolation (Mi₄) connectés de façon croisée, le bloc logique (210) de commande étant configuré en outre pour produire un signal de pilotage (Cmd_{c}) des grilles respectives desdits troisième et quatrième transistors d'isolation (Mi₁, Mi₂) et dans lequel :
- lorsque ladite autre valeur est une deuxième valeur correspondant à une sélection d'une première opération logique, en particulier de type OU ou de type ET, le bloc logique (210) de commande est configuré de sorte à produire un premier signal de pilotage (Cmd_{A}), un deuxième signal de pilotage (Cmd_{B}) distinct du premier signal de pilotage, de sorte à rendre passant le premier transistor d'isolation tout en rendant bloqué le deuxième transistor d'isolation,
- lorsque ladite autre valeur est une troisième valeur correspondant à une sélection d'une deuxième opération logique, en particulier de type ET ou de type OU: transmettre un premier signal de pilotage (Cmd_{A}) et un deuxième signal de pilotage de sorte à rendre bloqué le premier transistor d'isolation tout en rendant passant le deuxième transistor d'isolation,
- lorsque le signal numérique de sélection a une quatrième valeur correspondant à une sélection d'une troisième opération logique, en particulier de type XOR, ledit bloc logique de sélection est configuré de sorte à transmettre un premier signal de pilotage (Cmd_{A}) à la grille du premier transistor d'isolation (Mi₁) et un deuxième signal de pilotage à la grille du deuxième transistor d'isolation (Mi₂) identique au premier signal de pilotage, le troisième signal de pilotage (Cmd_{c}) étant dans un état distinct de celui du premier signal de pilotage (Cmd_{A}) et du deuxième signal de pilotage (Cmd_{B}).

8. Dispositif selon la revendication 2, comprenant :
- un premier transistor de réinitialisation (Mrz₁) couplé au deuxième nœud (N₁) et à la deuxième ligne d'alimentation (45), le premier transistor de réinitialisation (Mrz₁) ayant une grille commandée par le premier signal de commande (Cmd₁),
- un deuxième transistor de réinitialisation (Mrz₂) couplé au premier nœud (N₂) et à la deuxième ligne d'alimentation (45), le deuxième transistor de réinitialisation (Mrz₂) ayant une grille commandée par le premier signal de commande (Cmd₁).

9. Dispositif selon la revendication 2, comprenant : un transistor de réinitialisation (146) ayant une grille commandée par le premier signal de commande (Cmd₁), le transistor de réinitialisation (146) étant agencé entre ledit premier nœud (N₁) et ledit deuxième nœud (N₂).

10. Dispositif de mémoire résistive à accès aléatoire selon l'une des revendication 1 à 9, dans lequel ledit circuit de lecture est doté en outre, en sortie dudit amplificateur de détection (44₀), d'au moins un élément de mémorisation, configuré pour conserver une donnée produite en sortie dudit amplificateur de détection lors de ladite phase de comparaison après ledit basculement, ledit élément de mémorisation étant en particulier doté :
- d'une bascule RS dotée d'une entrée couplée au premier nœud de lecture (N1) et d'une autre entrée couplée au deuxième nœud de lecture (N2), ou
- d'une bascule D comprenant une entrée couplée au premier nœud de lecture (N1) ou au deuxième nœud de lecture (N2).

11. Dispositif selon l'une des revendication 1 à 10, dans lequel lors de phase de décharge partielle, la première ligne de bits (BL₀) est reliée à la deuxième ligne d'alimentation (45) par l'intermédiaire d'un premier transistor de réinitialisation rendu passant par le biais d'un premier signal de commande, et par l'intermédiaire du premier transistor de couplage rendu passant par le biais d'un deuxième signal de commande.

12. Dispositif de mémoire résistive à accès aléatoire selon la revendication 1, dans lequel lors d'une phase d'attente suivant une phase de comparaison d'une précédente opération de lecture, ledit amplificateur de détection est maintenu dans un état verrouillé après son basculement, sans réinitialisation, et dans lequel ladite première ligne de bits se recharge par un courant traversant au moins une cellule sélectionnée de ladite colonne.

13. Dispositif selon la revendication 12, dans lequel la phase de réinitialisation est réalisée uniquement en parallèle de la phase de décharge partielle.

14. Dispositif selon l'une des revendications 1 à 13, dans lequel parmi lesdits éléments interrupteurs figure au moins un élément interrupteur commandé par le biais d'un premier signal de commande (Cmd₁)et dans lequel ledit circuit de commande est doté en outre d'un premier comparateur (101) qui reçoit une tension mesurée de la première ligne de bit, et produit en sortie le premier signal de commande (Cmd₁) dont l'état dépend d'une comparaison effectuée par ledit premier comparateur (101) entre ladite tension mesurée et une tension référence prédéterminée (vref).

15. Dispositif selon la revendication 14, dans lequel ladite colonne est couplée à une première ligne de bits (BL₀,..., BLₘ₋₂) et à une deuxième ligne de bits (BL₁,..., BLₘ₋₁), et dans lequel le circuit de commande est doté d'un deuxième comparateur (112) qui reçoit une autre tension mesurée de ladite deuxième ligne de bits, l'état du premier signal de commande (Cmd₁) dépendant en outre d'une comparaison effectuée par ledit deuxième comparateur (101).

16. Dispositif selon l'une des revendications 1 à 15, dans lequel le dispositif comprend en outre :
- au moins un premier transistor dit « de repolarisation » (Mᵣₑₚ₁, M'ᵣₑₚ₁) agencé entre la première ligne de bit (BL₀) et ladite première ligne d'alimentation (SL), le premier transistor de repolarisation (BL₀) étant configuré pour, en fonction d'un signal de pilotage de repolarisation (Sᵣₑₚₒₗ) appliqué sur sa grille, alternativement coupler la première ligne d'alimentation (SL) à la première ligne de bit (BL₀) et découpler la première ligne d'alimentation (SL) de la première ligne de bit (BL₀), ledit premier transistor de repolarisation étant rendu conducteur dans une phase d'attente et non conducteur lors desdites phases de décharge partielle et de comparaison.

17. Dispositif selon l'une des revendications 1 à 16, dans lequel ledit au moins un premier transistor de couplage est ou comprend un premier transistor de séparation (M₆₁) entre la première ligne de bit (BL₀) et l'amplificateur de détection (44₀), le premier transistor de séparation (M₆₁) étant commandé par un signal de commande supplémentaire appelé « signal d'activation de lecture » (Enable_{read}), le circuit de commande étant configuré pour mettre ledit signal d'activation de lecture dans un état déterminé lors de ladite opération de lecture de sorte à rendre passant le premier transistor de séparation (M₆₁), et mettre ledit signal d'activation de lecture dans un autre état, distinct dudit état déterminé, lors d'une opération d'écriture sur la matrice de sorte à bloquer le premier transistor de séparation (M₆₁).

18. Dispositif selon la revendication 17, dans lequel ledit au moins un premier transistor de couplage inclue un transistor avec un diélectrique de grille plus épais que le diélectrique de grille de transistors constitutifs dudit amplificateur de détection.

## Patentansprüche

1. Widerstandsspeichervorrichtung mit Zufallszugriff (ReRAM), umfassend:
- eine Matrix (M₁) aus Speicherzellen (Cᵢⱼ), die jeweils mit einer ersten Versorgungsleitung (SL) verbunden sind, die auf ein erstes Versorgungspotenzial eingestellt ist, wobei jede Zelle der Matrix mindestens ein erstes Widerstandselement (1, 2) mit variablem Widerstand besitzt und in Reihe mit mindestens einem ersten Auswahltransistor (Ms₁, Ms₂) geschaltet ist,
- einen Lesekreis (40₀), der mit einer Zellenspalte der Matrix verbunden ist, wobei der Lesekreis Folgendes umfasst:
- einen Erkennungsverstärker (44₀) des Verriegelungstyps, der aus kreuzweise verbundenen Wechselrichtern besteht und mit einem ersten Leseknoten (N₁) und einem zweiten Leseknoten (N₂) versehen ist, wobei die Wechselrichter jeweils einen ersten Zweig und einen zweiten Zweig bilden, die jeweils auf einer Seite mit einer zweiten Versorgungsleitung (45) verbunden sind, die auf ein zweites Versorgungspotenzial eingestellt ist, das sich von dem ersten Versorgungspotenzial unterscheidet,
- mindestens einen ersten Kopplungstransistor (Mi₁, M₆₁), der eine andere Seite des ersten Zweiges mit einer ersten Bitleitung (BL₀) verbindet, die mit den jeweiligen ersten Widerstandselementen der Zellen der Spalte gekoppelt ist,
- mindestens einen zweiten Kopplungstransistor (Mi₂, M6₂), der eine andere Seite des zweiten Zweigs entweder mit einer zweiten Bitleitung (BL₁) verbindet, die mit zweiten Widerstandselementen der Zellen der Spalte gekoppelt ist, oder mit einer Referenzleitung, die einen Referenzstrom liefert;
- einen Steuerkreis für die Lesevorgänge auf der Matrix über Signale (Cmd₂, SWL, Cmd₁) zum Steuern von Schalterelementen, wobei der Steuerkreis so konfiguriert ist, dass er bei einem Lesevorgang an einer bestimmten Zelle der Spalte:
- nach einer Wartephase die erste Bitleitung (BL₀) auf ein Potenzial lädt, das gleich oder nahe oder im Wesentlichen gleich dem ersten Versorgungspotenzial (GND, VDD) ist, dann
- nach einer Rücksetzphase des Erkennungsverstärkers (44₀) über mindestens einen Rücksetztransistor (146, Mrz₁, Mrz₂) den ersten Leseknoten (N₁) und den zweiten Leseknoten (N₂) verbindet, so dass die Potenziale des ersten Leseknotens (N₁) und des zweiten Leseknotens (N₂) ausgeglichen werden;
- nach einer Teilentladungsphase die erste Bitleitung (BL₀) mit der zweiten Versorgungsleitung (45) verbindet und, wenn die Vorrichtung die zweite Bitleitung (BL₁) aufweist, die zweite Bitleitung mit der zweiten Versorgungsleitung (45) verbindet, so dass die erste Bitleitung oder die Bitleitungn teilweise entladen werden und an den Klemmen der Zellen der Spalte eine Potenzialdifferenz erhalten wird, die nicht null, aber geringer und insbesondere wesentlich geringer als eine Potenzialdifferenz zwischen dem ersten Versorgungspotenzial und dem zweiten Versorgungspotenzial ist, wobei die Rücksetzphase während der Teilentladungsphase ausgelöst wird; dann
- nach einer Vergleichsphase, in der der erste und der zweite Kopplungstransistor (Mi₁, Mi₂, M₆₁, M₆₂) durchgeschaltet werden und der mindestens eine Rücksetztransistor (146, Mrz₁, Mrz₂) nicht durchgeschaltet wird, einen ersten Stromfluss durch den ersten Zweig des Erkennungsverstärkers (44₀), die erste Bitleitung (BL₀) und ein erstes Widerstandselement der Zelle und einen zweiten Stromfluss durch den zweiten Zweig des Erkennungsverstärkers (44₀) sowie entweder die Referenzlinie oder die zweite Bitleitung (BL₁) und ein zweites Widerstandselement der Zelle ermöglicht, bis ein Umschalten des Erkennungsverstärkers in Abhängigkeit von einer Differenz zwischen dem ersten und dem zweiten Strom erfolgt.

2. Widerstandsspeichervorrichtung mit Zufallszugriff nach Anspruch 1, wobei unter den Schaltelementen mindestens ein erster Rücksetztransistor (146, Mrz₁, Mrz₂) enthalten ist, der zu einer Rücksetzstufe (46₀) des Erkennungsverstärkers (44₀) gehört und über ein erstes Steuersignal (Cmd₁) gesteuert wird, wobei der Steuerkreis zu Folgendem konfiguriert ist:
während der Rücksetzphase den ersten Rücksetztransistor (146, Mrz₁, Mrz₂) durchgeschaltet hält, so dass der erste Leseknoten (N₁) und der zweite Leseknoten (N₂) miteinander verbunden sind, oder den ersten Leseknoten (N₁) mit der zweiten Versorgungsleitung (45) verbindet oder eine erste Klemme und eine zweite Klemme des ersten Wechselrichters mit der zweiten Versorgungsleitung (45) verbindet, und
während der Vergleichsphase das erste Steuersignal (Cmd₁) in einen zweiten Zustand versetzt, der sich von dem ersten Zustand unterscheidet, so dass der erste Rücksetztransistor (146, Mrz₁, Mrz₂) nicht durchgängig ist.

3. Widerstandsspeichervorrichtung mit Zufallszugriff nach Anspruch 2, wobei der mindestens eine erste Kopplungstransistor ein erster Isolationstransistor (Mi₁) ist oder diesen umfasst, der zwischen dem Erkennungsverstärker (44₀) und der ersten Bitleitung (BL₀) angeordnet ist, wobei der erste Isolationstransistor (Mi₁) über mindestens ein zweites Steuersignal (Cmd₂, Cmd_{A}, Cmd_{B}) gesteuert wird, wobei der Steuerkreis ferner für Folgendes konfiguriert ist:
während der Wartephase das zweite Steuersignal (Cmd₂) in einen bestimmten Zustand versetzen, so dass der erste Isolationstransistor (Mi₁) blockiert wird und somit die erste Bitleitung (BL₀) des Erkennungsverstärkers (44₀) isoliert wird, und das erste Steuersignal (Cmd₁) in einen Zustand versetzen, so dass der erste Rücksetztransistor (146, Mrz₁, Mrz₂) durchgeschaltet wird, wobei der Steuerkreis ferner so konfiguriert ist, dass er während der Teilentladungs- und Vergleichsphasen das zweite Steuersignal (Cmd₂) in einen anderen Zustand versetzt, der sich von dem gegebenen Zustand unterscheidet, so dass der erste Isolationstransistor (Mi₁) durchgeschaltet wird und so die erste Bitleitung (BL₀) mit dem Erkennungsverstärker (44₀) verbunden wird.

4. Vorrichtung nach Anspruch 3, wobei die Speicherzellen (Cᵢⱼ) jeweils mit mindestens einem zweiten Widerstandselement (2) in Reihe mit einem zweiten Auswahltransistor (Ms₂) versehen sind, wobei die Zellenspalte mit der zweiten Bitleitung (BL₁,..., BL_{m_1}) gekoppelt ist, wobei der mindestens eine zweite Kopplungstransistor ein zweiter Isolationstransistor (Mi₂) zwischen dem Erkennungsverstärker (44₀) und der zweiten Bitleitung ist oder diesen umfasst, wobei der zweite Isolationstransistor (Mi₁, Mi₂) über das zweite Steuersignal (Cmd₂, Cmd_{A}, Cmd_{B}) gesteuert wird.

5. Widerstandsspeichervorrichtung mit Zufallszugriff nach Anspruch 4, wobei der Lesekreis (40₀) ferner Folgendes umfasst: einen dritten Isolationstransistor (Mi₃) und einen vierten Isolationstransistor (Mi₄), wobei der dritte Isolationstransistor (Mi₃) und der vierte Isolationstransistor (Mi₄) kreuzweise verbunden sind, so dass der dritte Isolationstransistor (Mi₃) eine erste Elektrode hat, die mit dem ersten Isolationstransistor (Mi₁) gekoppelt ist, und eine zweite Elektrode, die mit dem zweiten Isolationstransistor (Mi₂) gekoppelt ist, und so dass der vierte Isolationstransistor (Mi₄) eine erste Elektrode hat, die mit dem zweiten Isolationstransistor (Mi₂) gekoppelt ist, und eine zweite Elektrode, die mit dem ersten Isolationstransistor (Mi₁) gekoppelt ist.

6. Widerstandsspeichervorrichtung mit Zufallszugriff nach einem der Ansprüche 4 oder 5, die geeignet ist, Speichervorgänge, insbesondere mindestens einen logischen Vorgang, durchzuführen, wobei der Steuerkreis ferner mit Folgendem ausgestattet ist: einem Steuerlogikblock (210), der so konfiguriert ist, dass er Steuersignale (Cmd_{A}, Cmd_{B}) der jeweiligen Gatter der Isolationstransistoren (Mi₁, Mi₂) in Abhängigkeit von mindestens einem digitalen Betriebsmodusauswahlsignal, das an einem oder mehreren Eingängen (RegMODE<1>, RegMODE<0>) des Steuerlogikblocks ausgegeben wird, und einer flüchtigen logischen Angabe (Data_{VOL}) am Eingang des Steuerlogikblocks (210) erzeugt, um zwischen einem ersten Betriebsmodus des Lesekreises, der einem Lesevorgang entspricht, und mindestens einem anderen Betriebsmodus des Lesekreises, der der Umsetzung mindestens eines logischen Vorgangs zwischen mindestens einer in der Zelle der Zellenreihe gespeicherten nichtflüchtigen Angabe und der flüchtigen logischen Angabe (Data_{VOL}) am Eingang des Steuerlogikblocks (210) entspricht, wobei der Steuerlogikblock (210) für Folgendes konfiguriert ist:
- wenn das digitale Auswahlsignal einen ersten Wert hat, der einer Auswahl eines Lesevorgangs entspricht: Steuersignale (Cmd_{A}, Cmd_{B}) des Gatters des ersten Isolationstransistors (Mi₁) und des Gatters des zweiten Isolationstransistors (Mi₂) anlegen, die dem zweiten Steuersignal (Cmd₂) entsprechen,
- wenn das digitale Auswahlsignal einen anderen Wert als den ersten Wert hat und einer Auswahl einer logischen Operation entspricht: ein erstes Steuersignal (Cmd_{A}) an das Gatter des ersten Isolationstransistors (Mi₁) und ein zweites Steuersignal (Cmd_{B}) an das Gatter des zweiten Isolationstransistors (Mi₂) übertragen, so dass einer des ersten und des zweiten Isolationstransistors (Mi₁, Mi₂) blockiert wird, während der andere des ersten und des zweiten Isolationstransistors (Mi₁, Mi₂) durchgeschaltet wird.

7. Widerstandsspeichervorrichtung mit Zufallszugriff nach Anspruch 6, wobei der Lesekreis (40₀) ferner Folgendes umfasst: einen dritten Isolationstransistor (Mi₃) und einen vierten Isolationstransistor (Mi₄), die kreuzweise verbunden sind, wobei der Steuerlogikblock (210) ferner so konfiguriert ist, dass er ein Steuersignal (Cmd_{c}) der jeweiligen Gatter des dritten und des vierten Isolationstransistors (Mi₁, Mi₂) erzeugt, und wobei:
- wenn der andere Wert ein zweiter Wert ist, der einer Auswahl einer ersten logischen Verknüpfung, insbesondere vom Typ ODER oder vom Typ UND, entspricht, ist der Steuerlogikblock (210) so konfiguriert, dass er ein erstes Steuersignal (Cmd_{A}) und ein zweites Steuersignal (Cmd_{B}), das sich von dem ersten Steuersignal unterscheidet, erzeugt, so dass der erste Isolationstransistor durchgeschaltet wird, während der zweite Isolationstransistor blockiert wird,
- wenn der andere Wert ein dritter Wert ist, der einer Auswahl einer zweiten logischen Verknüpfung, insbesondere vom Typ UND oder vom Typ ODER, entspricht: Übertragen eines ersten Steuersignals (Cmd_{A}) und eines zweiten Steuersignals, so dass der erste Isolationstransistor blockiert wird, während der zweite Isolationstransistor durchgeschaltet wird,
- wenn das digitale Auswahlsignal einen vierten Wert aufweist, der einer Auswahl eines dritten logischen Vorgangs, insbesondere des Typs XOR, entspricht, ist der logische Auswahlblock so konfiguriert, dass er ein erstes Steuersignal (Cmd_{A}) an das Gatter des ersten Isolationstransistors (Mi₁) und ein zweites Steuersignal an das Gatter des zweiten Isolationstransistors (Mi₂) überträgt, das mit dem ersten Steuersignal identisch ist, wobei sich das dritte Steuersignal (Cmd_{c}) in einem anderen Zustand befindet als das erste Steuersignal (Cmd_{A}) und das zweite Steuersignal (Cmd_{B}).

8. Vorrichtung nach Anspruch 2, umfassend:
- einen ersten Rücksetztransistor (Mrz₁), der mit dem zweiten Knoten (N₁) und der zweiten Versorgungsleitung (45) gekoppelt ist, wobei der erste Rücksetztransistor (Mrz₁) ein vom ersten Steuersignal (Cmd₁) gesteuertes Gatter aufweist,
- einen zweiten Rücksetztransistor (Mrz₂), der mit dem ersten Knoten (N₂) und der zweiten Versorgungsleitung (45) gekoppelt ist, wobei der zweite Rücksetztransistor (Mrz₂) ein vom ersten Steuersignal (Cmd₁) gesteuertes Gatter aufweist.

9. Vorrichtung nach Anspruch 2, umfassend: einen Rücksetztransistor (146) mit einem Gatter, das durch das erste Steuersignal (Cmd₁) gesteuert wird, wobei der Rücksetztransistor (146) zwischen dem ersten Knoten (N₁) und dem zweiten Knoten (N₂) angeordnet ist.

10. Widerstandsspeichervorrichtung mit Zufallszugriff nach einem der Ansprüche 1 bis 9, wobei der Lesekreis ferner am Ausgang des Erkennungsverstärkers (44₀) mit mindestens einem Speicherelement ausgestattet ist, das so konfiguriert ist, dass es eine am Ausgang des Erkennungsverstärkers während der Vergleichsphase nach dem Umschalten erzeugte Angabe speichert, wobei das Speicherelement insbesondere mit Folgendem ausgestattet ist:
- einem RS-Flipflop mit einem Eingang, der mit dem ersten Leseknoten (N1) gekoppelt ist, und einem anderen Eingang, der mit dem zweiten Leseknoten (N2) gekoppelt ist, oder
- einem D-Flipflop, das einen Eingang umfasst, der mit dem ersten Leseknoten (N1) oder dem zweiten Leseknoten (N2) gekoppelt ist.

11. Vorrichtung nach einem der Ansprüche 1 bis 10, wobei während der Teilentladungsphase die erste Bitleitung (BL₀) über einen ersten Rücksetztransistor, der durch ein erstes Steuersignal durchgeschaltet wird, und über den ersten Rücksetztransistor, der durch ein zweites Steuersignal durchgeschaltet wird, mit der zweiten Versorgungsleitung (45) verbunden wird.

12. Widerstandsspeichervorrichtung mit Zufallszugriff nach Anspruch 1, wobei während einer Wartephase nach einer Vergleichsphase eines vorherigen Lesevorgangs der Erkennungsverstärker nach seinem Umschalten ohne Zurücksetzen in einem verriegelten Zustand gehalten wird und wobei die erste Bitleitung durch einen Strom geladen wird, der mindestens eine ausgewählte Zelle der Spalte durchläuft.

13. Vorrichtung nach Anspruch 12, wobei die Rücksetzphase nur parallel zur Teilentladungsphase durchgeführt wird.

14. Vorrichtung nach einem der Ansprüche 1 bis 13, wobei unter den Schaltelementen mindestens ein über ein erstes Steuersignal (Cmd₁) gesteuertes Schaltelement enthalten ist und wobei der Steuerkreis ferner einen ersten Komparator (101) aufweist, der eine gemessene Spannung der ersten Bitleitung empfängt, und am Ausgang das erste Steuersignal (Cmd₁) erzeugt, dessen Zustand von einem Vergleich abhängt, der von dem ersten Komparator (101) zwischen der gemessenen Spannung und einer vorbestimmten Referenzspannung (vref) durchgeführt wird.

15. Vorrichtung nach Anspruch 14, wobei die Spalte mit einer ersten Bitleitung (BL₀ ,..., BLₘ₋₂) und einer zweiten Bitleitung (BL₁ ,..., BLₘ-1) gekoppelt ist, und wobei der Steuerkreis einen zweiten Komparator (112) aufweist, der eine andere von der zweiten Bitleitung gemessene Spannung empfängt, wobei der Zustand des ersten Steuersignals (Cmd₁) ferner abhängig von einem Vergleich ist, der von dem zweiten Komparator (101) durchgeführt wird.

16. Vorrichtung nach einem der Ansprüche 1 bis 15, wobei die Vorrichtung ferner umfasst:
- mindestens einen ersten "Repolarisationstransistor" (Mᵣₑₚ₁, M'ᵣₑₚ₁), der zwischen der ersten Bitleitung (BL₀) und der ersten Versorgungsleitung (SL) angeordnet ist, wobei der erste Repolarisationstransistor (BL₀) so konfiguriert ist, dass er in Abhängigkeit von einem an seinem Gatter angelegten Repolarisationssteuersignal (Sᵣₑₚₒₗ) abwechselnd die erste Versorgungsleitung (SL) mit der ersten Bitleitung (BL₀) koppelt und die erste Versorgungsleitung (SL) von der ersten Bitleitung (BL₀) entkoppelt, wobei der erste Repolarisationstransistor in einer Wartephase leitfähig und während der Teilentladungs- und Vergleichsphasen nicht leitfähig wird.

17. Vorrichtung nach einem der Ansprüche 1 bis 16, wobei der mindestens eine erste Kopplungstransistor ein erster Trenntransistor (M₆₁) zwischen der ersten Bitleitung (BL₀) und dem Erkennungsverstärker (44₀) ist oder diesen umfasst, wobei der erste Trenntransistor (M₆₁) durch ein zusätzliches Steuersignal namens "Leseaktivierungssignal" (Enable_{read}) gesteuert wird, wobei der Steuerkreis so konfiguriert ist, dass er das Leseaktivierungssignal während des Lesevorgangs in einen bestimmten Zustand versetzt, so dass der erste Trenntransistor (M₆₁) durchgeschaltet wird, und dass sie das Leseaktivierungssignal während eines Schreibvorgangs auf die Matrix in einen anderen Zustand versetzt, der sich von dem bestimmten Zustand unterscheidet, so dass der erste Trenntransistor (M₆₁) blockiert wird.

18. Vorrichtung nach Anspruch 17, wobei der mindestens eine erste Kopplungstransistor einen Transistor mit einem Gatterdielektrikum einschließt, das dicker ist als das Gatterdielektrikum der Transistoren, aus denen der Erkennungsverstärker besteht.

## Claims

1. Resistive random-access memory (ReRAM) device comprising:
- a matrix (M₁) of memory cells (Cᵢⱼ) each connected to a first power supply line (SL) set to a first power supply potential, each cell of said matrix being provided with at least one first resistive element (1, 2) of variable resistivity and in series with at least one first selection transistor (Ms₁, Ms₂),
- a reading circuit (40₀) associated with a column of cells of the matrix, the reading circuit comprising:
- a detection amplifier (44₀) of the locking type formed of cross-connected inverters and provided with a first reading node (N₁) and a second reading node (N₂), said inverters forming respectively a first branch and a second branch each connected on one side to a second power supply line (45) set to a second power supply potential, separate from said first power supply potential,
- at least one first coupling transistor (Mi₁, M₆₁) connecting another side of said first branch to a first bit line (BL₀) coupled to the respective first resistive elements of the cells of said column,
- at least one second coupling transistor (Mi₂, M₆₂) connecting another side of said second branch either to a second bit line (BL₁) coupled to second resistive elements of the cells of said column, or to a reference line delivering a reference current;
- a circuit for controlling the reading operations on the matrix by means of signals (Cmd₂, SWL, Cmd₁) for controlling switch elements, said control circuit being configured to, during a reading operation performed on a given cell of said column:
- according to a waiting phase, charge said first bit line (BL ₀) at a potential equal to or close to or substantially equal to said first power supply potential (GND, VDD), then,
- according to a phase of resetting said detection amplifier (44₀), by means of at least one reset transistor (146, Mrz₁, Mrz₂) connecting the first reading node (N₁) and the second reading node (N₂), so as to equalise the potentials of the first reading node (N₁) and of the second reading node (N₂);
- according to a partial discharge phase, connect the first bit line (BL₀) to the second power line (45) and, when the device includes the second bit line (BL₁), connect the second bit line to the second power line (45), so as to partially discharge said first bit line or said bit lines and obtain at the terminals of the cells of said column a non-zero potential difference while being lower, and in particular much lower, than a difference in potentials between the first supply potential and said second supply potential, the reset phase being triggered during the partial discharge phase; then
- according to a comparison phase, in which said first and second coupling transistors (Mi₁, Mi₂, M₆₁, M₆₂) are switched on, and said at least one reset transistor (146, Mrz₁, Mrz₂) is switched off, to allow a first current to flow through said first branch of said detection amplifier (44₀), the first bit line (BL₀) and a first resistive element of said cell and a circulation of a second current through said second branch of said detection amplifier (44₀) as well as either the reference line or the second bit line (BL₁) and a second resistive element of said cell, until a switchover of said detection amplifier according to a difference between said first and second currents.

2. Resistive random-access memory device according to claim 1, wherein said switch elements include at least one first reset transistor (146, Mrz₁, Mrz₂) belonging to a reset stage (46₀) of said detection amplifier (44₀), and controlled by means of a first control signal (Cmd₁), said control circuit being configured to:
during said reset phase, keep the first reset transistor (146, Mrz₁, Mrz₂) switched on, so as to connect together the first reading node (N₁) and the second reading node (N₂), or to connect the first read node (N₁) to the second power line (45) or to connect a first terminal and a second terminal of the first inverter to the second power line (45), and
during the comparison phase, put the first control signal (Cmd₁) into a second state, distinct from said first state, such that said first reset transistor (146, Mrz₁, Mrz₂) is off.

3. Resistive random-access memory device according to claim 2, wherein said at least one first coupling transistor is or comprises a first isolation transistor (Mi₁) arranged between said detection amplifier (44₀) and said first bit line (BL₀), said first isolation transistor (Mi₁) being controlled via at least one second control signal (Cmd₂, Cmd_{A}, Cmd_{B}), the control circuit being further configured to:
during the waiting phase, put said second control signal (Cmd₂) in a given state so as to switch off the first isolation transistor (Mi₁) and thus isolate the first bit line (BL₀) from said detection amplifier (44₀) and put said first control signal (Cmd₁) in a state so as to keep the first reset transistor (146, Mrz₁, Mrz₂) on, said control circuit being further configured to, during said partial discharge and comparison phases: put said second control signal (Cmd₂) in another state, distinct from said given state, so as to switch on the first isolation transistor (Mi₁) and thus connect the first bit line (BL₀) to said detection amplifier (44₀).

4. Device according to claim 3, wherein the memory cells (Cᵢⱼ) are each provided with at least one second resistive element (2) in series with a second selection transistor (Ms₂), said column of cells being coupled to said second bit line (BL₁ ,..., BL_{m_1}), said at least one second coupling transistor being or comprising a second isolation transistor (Mi₂) between the detection amplifier (44₀) and said second bit line, the second isolation transistor (Mi₁, Mi₂) being controlled via said second control signal (Cmd₂, Cmd_{A}, Cmd_{B}).

5. Resistive random-access memory device according to claim 4, wherein the read circuit (40₀) further comprises: a third isolation transistor (Mi₃) and a fourth isolation transistor (Mi₄), the third isolation transistor (Mi₃) and the fourth isolation transistor (Mi₄) being cross-connected so that the third isolation transistor (Mi₃) has a first electrode coupled to the first isolation transistor (Mi₁) and a second electrode coupled to the second isolation transistor (Mi₂) and such that the fourth isolation transistor (Mi₄) has a first electrode coupled to the second isolation transistor (Mi₂) and a second electrode coupled to the first isolation transistor (Mi₁).

6. The random access resistive memory device according to one of claims 4 or 5, capable of performing memory operations, in particular at least one logical operation, said control circuit further being provided with: a control logic block (210) configured to produce control signals (Cmd_{A}, Cmd_{B}) of the respective gates of said isolation transistors (Mi₁, Mi₂) according to at least one digital operating mode selection signal transmitted on one or more inputs (RegMODE<1>, RegMODE<0>) of said control logic block and a volatile logical data (Data _{VOL}) at the input of said control logic block (210), to select between a first mode of operation of the reading circuit corresponding to a reading operation and at least one other mode of operation of the reading circuit corresponding to the implementation of at least one logical operation between at least one non-volatile data item stored in said given cell of said given row of cells and the volatile logical data item (Data _{VOL}) at the input of said logic block (210) of control, said logic block (210) control module being configured to:
- when the digital selection signal has a first value corresponding to a selection of a reading operation: apply signals (Cmd_{A}, Cmd_{B}) controlling the gate of the first isolation transistor (Mi₁) and to the gate of the second isolation transistor (Mi₂) corresponding to the second control signal (Cmd₂),
- when the digital selection signal has another value distinct from the first value and corresponding to a selection of a logical operation: transmit a first control signal (Cmd_{A}) to the gate of the first isolation transistor (Mi₁) and a second control signal (Cmd_{B}) to the gate of the second isolation transistor (Mi₂), so as to switch off one of said first and second isolation transistors (Mi ₁, Mi₂) while switching on the other of said first and second isolation transistors (Mi ₁, Mi₂).

7. Resistive random-access memory device according to claim 6, wherein the reading circuit (40₀) further comprises: a third isolation transistor (Mi₃) and a fourth isolation transistor (Mi₄) cross-connected, the control logic unit (210) further being configured to produce a signal (Cmd_{c}) controlling the respective gates of said third and fourth isolation transistors (Mi₁, Mi₂) and wherein:
- when said other value is a second value corresponding to a selection of a first logical operation, in particular of the OR type or of the AND type, the control logic unit (210) is configured so as to produce a first control signal (Cmd_{A}), a second control signal (Cmd_{B}) distinct from the first control signal, so as to switch the first isolation transistor on while switching off the second isolation transistor,
- when said other value is a third value corresponding to a selection of a second logical operation, in particular of the AND type or of the OR type: transmitting a first control signal (Cmd_{A}) and a second control signal so as to switch the first isolation transistor of while switching on the second isolation transistor,
- when the digital selection signal has a fourth value corresponding to a selection of a third logical operation, in particular of the XOR type, said selection logic unit is configured so as to transmit a first control signal (Cmd_{A}) to the gate of the first isolation transistor (Mi₁) and a second control signal to the gate of the second isolation transistor (Mi₂) identical to the first control signal, the third control signal (Cmd_{c}) being in a state distinct from that of the first control signal (Cmd_{A}) and the second control signal (Cmd_{B}).

8. Device according to claim 2, comprising:
- a first reset transistor (Mrz₁) coupled to the second node (N₁) and to the second power line (45), the first reset transistor (Mrz₁) having a gate controlled by the first control signal (Cmd₁),
- a second reset transistor (Mrz₂) coupled to the first node (N₂) and to the second power line (45), the second reset transistor (Mrz₂) having a gate controlled by the first control signal (Cmd₁).

9. Device according to claim 2, comprising: a reset transistor (146) having a gate controlled by the first control signal (Cmd₁), the reset transistor (146) being arranged between said first node (N₁) and said second node (N₂).

10. Resistive random-access memory device according to one of claims 1 to 9, wherein said reading circuit is further provided, at the output of said detection amplifier (44₀), with at least one memory element, configured to store data produced at the output of said detection amplifier during said comparison phase after said switching, said memory element being in particular provided with:
- an RS latch equipped with an input coupled to the first reading node (N1) and another input coupled to the second reading node (N2), or
- a D latch comprising an input coupled to the first reading node (N1) or to the second reading node (N2).

11. Device according to one of claims 1 to 10, wherein, during a partial discharge phase, the first bit line (BL₀) is connected to the second power line (45) via a first reset transistor switched on by a first control signal, and via the first coupling transistor switched on by a second control signal.

12. Resistive random-access memory device according to claim 1, wherein, during a waiting phase following a comparison phase of a previous reading operation, said detection amplifier is maintained in a locked state after switching though of, without resetting, and wherein said first bit line is recharged by a current passing through at least one selected cell of said column.

13. Device according to claim 12, wherein the reset phase is implemented only in parallel with the partial discharge phase.

14. Device according to one of claims 1 to 13, wherein among said switch elements there is at least one switch element controlled by means of a first control signal (Cmd₁) and wherein said control circuit is further provided with a first comparator (101) which receives a measured voltage from the first bit line, and produces an output the first control signal (Cmd₁) the state of which depends on a comparison made by said first comparator (101) between said measured voltage and a predetermined reference voltage (vref).

15. Device according to claim 14, wherein said column is coupled to a first bit line (BL₀ ,..., BLₘ₋₂) and to a second bit line (BL₁ ,..., BLₙ₋₁), and wherein the control circuit is provided with a second comparator (112) which receives another measured voltage from said second bit line, the state of the first control signal (Cmd₁) further depending on a comparison performed by said second comparator (101).

16. Device according to any one of claims 1 to 15, wherein the device further comprises:
- at least one first so-called "re-biasing" transistor (M ᵢₜₑₘ 1, M' ᵢₜₑₘ 1) arranged between the first bit line (BL₀) and said first power supply line (SL), the first re-biasing transistor (BL₀) being configured to, according to a re-biasing control signal (Sᵣₑₚₒₗ) applied on its gate, alternately couple the first power supply line (SL) to the first bit line (BL₀) and decouple the first power supply line (SL) from the first bit line (BL₀), said first re-biasing transistor being switched on in a waiting phase and off during said partial discharge and comparison phases.

17. Device according to one of claims 1 to 16, wherein said at least one first coupling transistor is or comprises a first separation transistor (M₆₁) between the first bit line (BL₀) and the detection amplifier (44₀), the first separation transistor (M₆₁) being controlled by an additional control signal called a "read enable signal" (Enable_{read}), the control circuit being configured to put said read enable signal in a determined state during said reading operation so as to switch on the first separation transistor (M₆₁) and put said read enable signal in another state, distinct from said determined state, during a writing operation on the matrix so as to switch off the first separation transistor (M₆₁).

18. Device according to claim 17, wherein said at least one first coupling transistor includes a transistor with a gate dielectric thicker than the gate dielectric of transistors constituting said detection amplifier.
